# EUROPEAN PATENT SPECIFICATION

(11) **EP 2 924 679 B1**
(45) Date of publication and mention of the grant of the patent: **15.08.2018**
(21) Application number: 13856935.5
(22) Date of filing: 14.11.2013
(51) Int. Cl.: H01L 29/786, H01L 27/12, G02F 1/1368, G02F 1/1362

(54) **DISPLAY APPARATUS**
ANZEIGEVORRICHTUNG
APPAREIL D'AFFICHAGE

(30) Priority: 21.11.2012 JP 2012255514
(43) Date of publication of application: 30.09.2015
(73) Proprietor: Sharp Kabushiki Kaisha, Osaka-shi, Osaka 545-8522 (JP)
(72) Inventor: TAKANISHI, Yudai, Osaka-shi Osaka 545-8522 (JP); HARA, Yoshihito, Osaka-shi Osaka 545-8522 (JP); NAKATA, Yukinobu, Osaka-shi Osaka 545-8522 (JP)
(74) Representative: Müller-Boré & Partner Patentanwälte PartG mbB
(86) International application number: PCT/JP2013/080752
(87) International publication number: WO 2014/080826

(56) References cited:
- JP-A- 2009 141 002
- JP-A- 2009 141 002
- JP-A- 2011 091 376
- JP-A- 2011 258 949
- JP-A- 2012 028 761
- JP-A- 2012 204 548
- JP-A- 2012 227 533
- US-A1- 2012 175 609

## Description

### TECHNICAL FIELD

The present invention relates to a display device.

### BACKGROUND ART

A liquid crystal panel in a liquid crystal display device includes a number of TFTs disposed in a matrix. The TFTs are switching components for controlling operations of pixels. Silicon semiconductors including amorphous silicon semiconductors have been commonly used for semiconductor films in the TFTs. In recent years, use of oxide semiconductors having higher electron mobility for semiconductor films is proposed. An example of a liquid crystal display device including TFTs using such oxide semiconductors as switching components is disclosed in Patent Document 1.

JP 2012 028761 A discloses a manufacturing method of a semiconductor device using crack prevention layer for a periphery of a semiconductor element.

JP 2011 258949 A discloses a thin film transistor display panel having high charge mobility and capable of achieving uniform electrical characteristics with respect to a large-area display device.

JP 2012 227533 A discloses a display device using a transistor with excellent electric characteristics and high reliability.

JP 2012 204548 A discloses a display device in which the cross capacity can be reduced while minimizing the characteristic deterioration of a TFT.

JP 2009 141002 A discloses an oxide semiconductor element having an insulating layer in contact with an oxide semiconductor layer. The insulating layer comprises a first insulating layer comprising an oxide composed of O and Si having a film thickness of 50 nm or larger in contact with an oxide semiconductor, a second insulating layer comprising a nitride composed of N and Si having a film thickness of 50 nm or larger in contact with the first insulating layer, and a third insulating layer in contact with the second insulating layer.

JP 2011 091376 A discloses a display device having a driving circuit including a logic circuit having a depletion type first transistor and an enhancement type second transistor, a signal line electrically connected to the driving circuit, a pixel unit including a pixel of which display condition is controlled by input of a signal serving as pixel data from the driving circuit through the signal line, a reference-voltage line to which the voltage working for reference is applied, and a depletion type third transistor to control the conduction between the signal line and the reference-voltage line. The first to the third transistors include an oxide semiconductor layer having a channel-forming region.

US 2012/175609 A1 discloses a semiconductor device and a manufacturing method thereof.

### RELATED ART DOCUMENT

### Patent Document

Patent Document 1: Japanese Unexamined Patent Application Publication No. 2011-29373

### Problem to be Solved by the Invention

An oxide semiconductor has high electron movability. Therefore, sizes of TFTs can be reduced and an aperture ratio of a liquid crystal panel can be increased. Furthermore, various circuits can be disposed on an array board on which the TFTs are disposed. However, if an oxide semiconductor takes moisture therein, electrical characteristics of the oxide semiconductor are more likely to change. This may cause malfunctions of the circuits.

### DISCLOSURE OF THE PRESENT INVENTION

The present invention was made in view of the above circumstances. A problem of the present invention is to provide technology for reducing malfunctions of non-display area transistors. This problem is solved by the display device according to appended claim 1. Preferred embodiments are defined in the appended dependent claims.

### Means for Solving the Problem

A display device according to the present invention includes a substrate, a display area transistor, a non-display area transistor, a gate electrode, an oxide semiconductor film, a source electrode, a drain electrode, and an insulator. The substrate includes a display area and a non-display area. The display area is configured to display image and located medially. The non-display area is located closer to peripheral edges of the substrate so as to surround the display area. The display area transistor is disposed in the display area. The non-display area transistor is disposed in the non-display area. The gate electrode is included in the non-display area transistor. The oxide semiconductor film is included in the non-display area transistor. At least a portion of the oxide semiconductor film overlaps the gate electrode in a plan view. The source electrode is included in the non-display area transistor. At least a portion of the source electrode is layered on the oxide semiconductor film in a plan view and connected to the oxide semiconductor film. The drain electrode is included in the non-display area transistor. At least a portion of the drain electrode is layered on the oxide semiconductor film and connected to the oxide semiconductor film with a gap between the source electrode and the drain electrode. The insulator is layered on the source electrode and the drain electrode. The insulator has a multilayer structure including a lower insulator and an upper insulator. The lower insulator is disposed in a lower layer. The lower insulator is made of silicon oxide.
The upper insulator is disposed in an upper layer. The upper insulator is made of silicon nitride. The upper insulator has a thickness in a range from 35 nm to 75 nm.

According to the configuration, in the non-display area transistor, a current flows between the source electrode and the drain electrode via the oxide semiconductor film when a voltage is applied to the gate electrode. In comparison to an amorphous silicon thin film, the oxide semiconductor film has higher electron mobility. This configuration is preferable for passing a large current between the source electrode and the drain electrode.

In the substrate having the configuration in which the non-display area is disposed closer to the peripheral edges so as to surround the display area disposed medially, the non-display area transistor in the non-display area is more likely to be subject to moisture that exists outside in comparison to the display area transistor in the display area. If the oxide semiconductor film in the non-display area transistor takes the moisture therein from the outside and degrades, electrical characteristics of the oxide semiconductor film change. The non-display area transistor may not function properly.

The insulators layered at least on the source electrode and the drain electrode has the multilayer structure including the lower insulator and the upper insulator. The lower insulator is disposed in the lower layer. The lower insulator contains at least silicon and oxygen. The upper insulator is disposed in the upper layer. The upper insulator contains at least silicon and nitrogen. With upper insulator, the moisture from the outside is less likely to reach the oxide semiconductor film. Even if the upper insulator contains hydrogen during the formation of the upper insulator and the hydrogen is desorbed from the upper insulator, the hydrogen desorbed from the upper insulator is less likely to reach the oxide semiconductor film because of the lower insulator. Therefore, the oxide semiconductor is less likely to deteriorate due to the moisture and the hydrogen taken into the oxide semiconductor and thus the electrical characteristics are less likely to change. A malfunction of the non-display area transistor is less likely to occur.

If the thickness of the upper insulator is larger than 75 nm, a large amount of hydrogen is contained in the upper insulator during the formation of the upper insulator. Furthermore, the amount of hydrogen desorbed from the upper insulator tends to increase. Therefore, the oxide semiconductor film may be deteriorated by the hydrogen desorbed from the upper insulator and the electrical characteristics thereof are more likely to change. If the thickness of the upper insulator is smaller than 35 nm, the coverage of the upper insulator to the lower insulator decreases. The cracks (gaps) are more likely to be created and thus the moisture resistance decreases. As a result, he oxide semiconductor film is more likely to take the moisture therein. When the thickness of the upper insulator is in the range from 35 nm to 75 nm, the amount of hydrogen desorbed from the upper insulator is small. The sufficient moisture resistance of the upper insulator is provided and the electrical characteristics of the oxide semiconductor film are less likely to change. Therefore, the malfunction of the non-display area transistor is less likely to occur. Because the upper insulator has the sufficient moisture resistance, the source electrode and the drain electrode are less likely to be corroded by the moisture.

The display device further includes a protection film made of silicon oxide for protecting the oxide semiconductor film. The protection film is disposed between the source electrode and the oxide semiconductor film and between the drain electrode and the oxide semiconductor film. The protection film includes a pair of holes formed at positions overlapping the source electrode and the drain electrode, respectively, in a plan view and through which the source electrode and the drain electrode are connected to the oxide semiconductor film. According to the configuration, during etching for forming the source electrode and the drain electrode in the fabrication process, the oxide semiconductor film is protected by the protection film in the upper layer from being etched. After the fabrication, the oxide semiconductor film is protected by the protection film. The hydrogen is less likely to be taken into the oxide semiconductor film and thus the malfunction of the non-display area transistor is less likely to occur.

Preferable embodiments may include the following configurations:
(1) The upper insulator of the insulator may have a refractive index in a range from 1.5 to 1.9. The refractive index of the upper insulator varies according to the composition. Specifically, if the content of the nitrogen decreases, the refractive index tends to decrease. If the content of the nitrogen increases, the refractive index tends to increase. If the refractive index of the upper insulator is equal to or smaller than 1.5, the content of nitrogen is small and thus the moisture resistance is low. Namely, the moisture is more likely to enter the oxide semiconductor film, which may results in adverse effect on the electrical characteristics of the oxide semiconductor film. If the refractive index of the upper insulator is equal to or larger than 1.9, the content of nitrogen is large and thus it may be difficult to form the film by general fabrication equipment. If the refractive index of the upper insulator is in the range from 1.5 to 1.9, the sufficient moisture resistance is ensured. The electrical characteristics of the oxide semiconductor film are less likely to change and thus the film is easily formed by general fabrication equipment.
(2) The refractive index of the upper insulator of the insulator is may be in a range from 1.5 to 1.72. The content of hydrogen in the upper insulator during the formation of the film tends to increase as the content of nitrogen increases. By setting the upper limit of the refractive index of the upper insulator to 1.72, a small amount of hydrogen is contained in the upper insulator. The amount of hydrogen desorbed from the upper insulator is small and thus the electrical characteristics of the oxide semiconductor film are less likely to change due to the hydrogen desorbed from the upper insulator.
(3) The display device may further include a counter substrate, liquid crystals, and a sealing member. The counter substrate may be disposed opposite the substrate. The liquid crystals are sandwiched between the substrate and the counter substrate. The sealing member is disposed between the substrate and the counter substrate so as to surround the liquid crystals and seals the liquid crystals. The non-display area transistor is disposed closer to the sealing member than the display area transistor. According to the configuration, the liquid crystals sandwiched between the substrate and the counter substrate are sealed by the sealing member disposed between the substrate and the counter substrate so as to surround the liquid crystals . The non-display area transistor is closer to the sealing member than the display area transistor. If the moisture from the outside permeates the sealing member, the non-display area transistor is subject to the moisture. As described above, the insulator has the multilayer structure including the upper insulator and the lower insulator and the thickness of the upper insulator is in the range from 35 nm to 75 nm. Therefore, the oxide semiconductor film in the non-display area transistor is less likely to take the moisture that permeates the sealing member therein and thus the malfunction of the non-display transistor is less likely to occur.
(4) The oxide semiconductor film may include an extending portion that projects toward an opposite direction to the source electrode at a position at which the drain electrode is connected. At least a portion of the extending portion may not overlap the gate electrode in a plan view. The oxide semiconductor film may have such a configuration. Namely, the oxide semiconductor film may include the extending portion that projects toward an opposite direction to the source electrode at a position at which the drain electrode is connected. At least a portion of the extending portion may not overlap the gate electrode in a plan view. According to the configuration, light from the outside toward the non-overlapping portion of the extending portion is less likely to be blocked by the gate electrode. Therefore, the non-overlapping portion is subject to irradiation of the light from the outside and thus the electrical characteristics thereof may degrade. Specifically, the oxide semiconductor film has characteristics that the flow of electric charge tends to be easily affected by energy of light. During driving of the non-display area transistor, electric charge may build up in the non-overlapping portion of the extending portion. Such a problem tends to result in a malfunction of the non-display transistor together with the problem that the oxide semiconductor film deteriorates caused by the moisture taken into the oxide semiconductor film. As described above, the insulator has the multilayer structure including the upper insulator and the lower insulator and the thickness of the upper insulator is in the range from 35 nm to 75 nm. Therefore, the moisture and the hydrogen are less likely to be taken into the oxide semiconductor film and thus the malfunction of the non-display area transistor is less likely to occur.
(5) The protection film may include the pair of holes formed at positions that overlap the source electrode and the drain electrode, respectively, in a plan view. The source electrode and the drain electrode may be connected to the oxide semiconductor film through the holes.
(6) The protection film may contain at least silicon and oxygen. According to the configuration, that is, the protection film may contain at least silicon and oxygen, the amount of hydrogen desorbed from the protection film is small. The hydrogen is less likely to be taken into the oxide semiconductor film and thus the malfunction of the non-display area transistor is less likely to occur.
(7) The oxide semiconductor film may contain at least indium, gallium, and zinc. The oxide semiconductor film that contains at least indium, gallium, and zinc may tend to deteriorate due to the moisture or the hydrogen. As described above, the insulator has the multilayer structure including the upper insulator and the lower insulator and the thickness of the upper insulator is in the range from 35 nm to 75 nm. Therefore, the moisture and the hydrogen are less likely to be taken into the oxide semiconductor film and thus the malfunction of the non-display area transistor is less likely to occur.
(8) The display device may further include a scan signal line and a buffer circuit. The scan signal line may be disposed in the display area and connected to the display area transistor to transmit scan signals to the display area transistor. The buffer circuit may be disposed in the non-display area and connected to the scan signal line. The non-display area transistor may be included in the buffer circuit. According to the configuration, in the non-display area transistor in the buffer circuit, a current that flows between the source electrode and the drain electrode tends to be larger in comparison to the display area transistor. The malfunction of the non-display area transistor due to change in electrical characteristics caused by the moisture or the hydrogen taken into the oxide semiconductor film in the non-display area transistor is more likely to occur. As described above, the insulator has the multilayer structure including the upper insulator and the lower insulator and the thickness of the upper insulator is in the range from 35 nm to 75 nm. Therefore, the moisture and the hydrogen are less likely to be taken into the oxide semiconductor film and thus the malfunction of the non-display area transistor in the buffer circuit is less likely to occur.
(9) The source electrode and the drain electrode may contain at least copper. In comparison to a source electrode and a drain electrode each containing aluminum, the source electrode and the drain electrode each containing copper have higher electrical conductivities but tend to be corroded by the moisture. As described above, the insulator has the multilayer structure including the upper insulator and the lower insulator and the thickness of the upper insulator is in the range from 35 nm to 75 nm. Therefore, the moisture from the outside is less likely to permeate through the insulator and to reach the source electrode and the drain electrode and thus the source electrode and the drain electrode are less likely to be corroded by the moisture.

### Advantageous Effect of the Invention

According to the present invention, a malfunction of the non-display area transistor is less likely to occur.

### BRIEF DESCRIPTION OF THE DRAWINGS

FIG. 1 is a schematic plan view of a liquid crystal panel on which a driver is mounted, a flexible printed circuit board, and a control circuit board illustrating connection among those.
FIG. 2 is a schematic cross-sectional view of a liquid crystal display device illustrating a cross-sectional configuration along a long-side direction thereof.
FIG. 3 is a schematic cross-sectional view illustrating an overall cross-sectional configuration of the liquid crystal panel.
FIG. 4 is a schematic cross-sectional view illustrating a cross-sectional configuration of the liquid crystal panel in a display area.
FIG. 5 is a plan view illustrating a wiring configuration on an array board in the liquid crystal panel.
FIG. 6 is a plan view illustrating wiring of display area TFTs.
FIG. 7 is a plan view illustrating a plane configuration of a display area TFT.
FIG. 8 is a cross-sectional view illustrating a cross-sectional configuration of the display area TFT along line viii-viii in FIG. 7.
FIG. 9 is a cross-sectional view illustrating a cross-sectional configuration of a non-display area TFT according to an embodiment of the present invention.
FIG. 10 is a graph illustrating a relationship between a refractive index of an upper first interlayer insulator and an amount of moisture desorbed from the upper first interlayer insulator in comparative experiment 1.
FIG. 11 is a graph illustrating a relationship between the refractive index of the upper interlayer insulator and the amount of moisture desorbed from the upper first interlayer insulator in comparative experiment 1.
FIG. 12 is a graph illustrating current-voltage characteristics regarding non-display area TFTs in comparative experiment 2.
FIG. 13 is a picture illustrating a cross-sectional configuration of the upper first interlayer in sample 1 in comparative experiment 3.
FIG. 14 is a picture illustrating a cross-sectional configuration of the upper first interlayer in sample 1 in comparative experiment 3.
FIG. 15 is a schematic cross-sectional view illustrating a cross-sectional configuration of a liquid crystal panel in a display area.
FIG. 16 is a cross-sectional view illustrating a cross-sectional configuration of a display area TFT.
FIG. 17 is a plan view illustrating a plane configuration of a display area TFT.
FIG. 18 is a cross-sectional view illustrating a cross-sectional configuration of the display area TFT along line xviii-xviii in FIG. 17.
FIG. 19 is a cross-sectional view illustrating a cross-sectional configuration of a non-display area TFT

### MODE FOR CARRYING OUT THE INVENTION

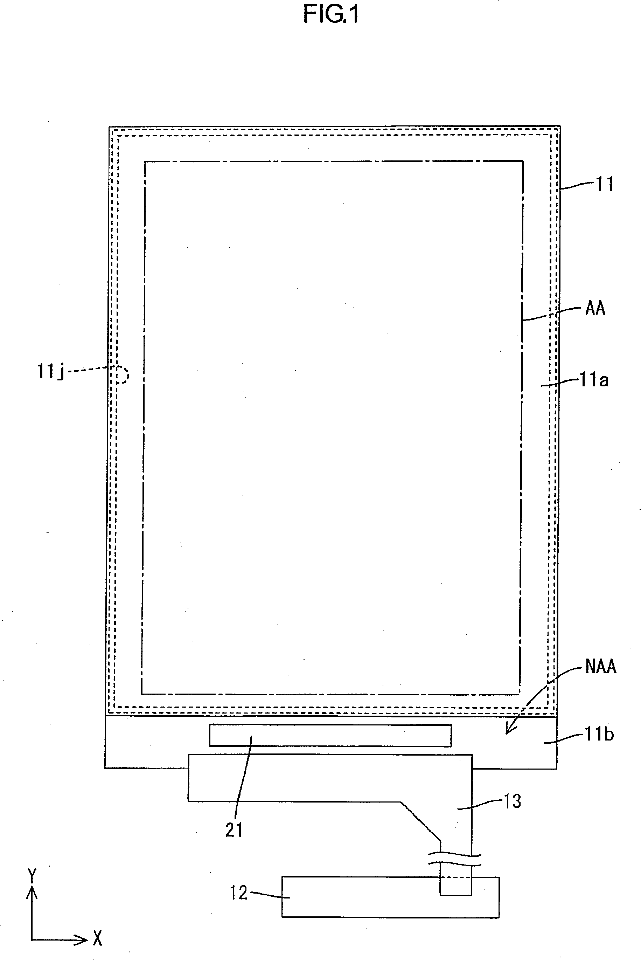

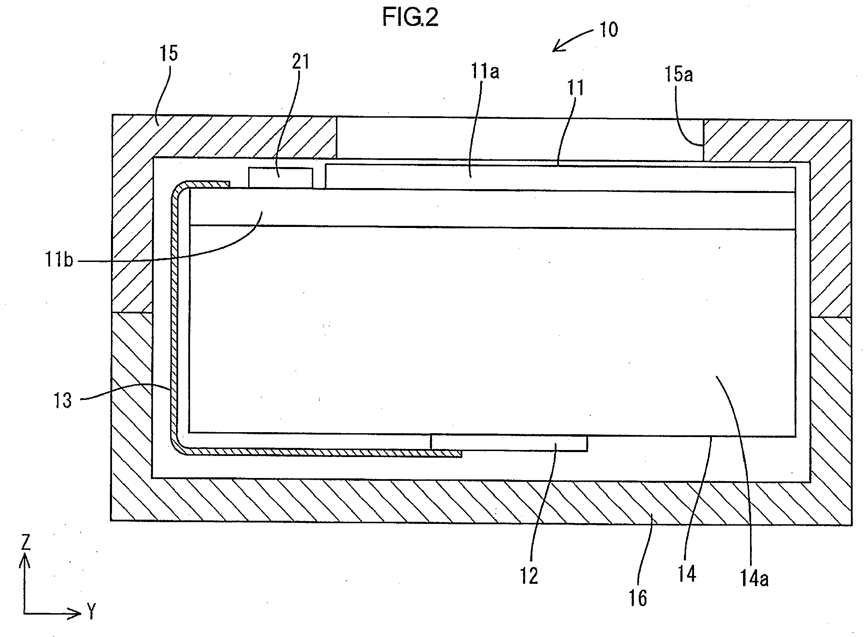

with reference to FIGS. 1 to 14 a liquid crystal display device 10 will be described. X-axis, Y-axis and Z-axis may be indicated in the drawings. The axes in each drawing correspond to the respective axes in other drawings . The vertical direction is defined based on FIGS. 2 to 4. An upper side and a lower side in each of FIGS. 2 to 4 correspond to a front side and a back side of the liquid crystal display device 10, respectively.

As illustrated in FIGS. 1 and 2, the liquid crystal display device 10 includes a liquid crystal panel (a display device, a display panel) 11, a driver (a panel driver) 21, a control circuit board (an external signal source) 12, a flexible printed circuit board (an external connecting component) 13, and a backlight unit (a backlight device) 14. The liquid crystal panel 11 includes a display area AA and a non-display area NAA. The display area AA is configured to display images and located medially. The non-display area NAA is located closer to peripheral edges of the liquid crystal panel 11 so as to surround the display area AA. The driver 21 is configured to drive the liquid crystal panel 11. The control circuit board 12 is configured to supply various input signals from the outside to the driver 21. The flexible printed circuit board 13 electrically connects the liquid crystal panel 11 to the control circuit board 12 outside the liquid crystal panel 11. The backlight unit 14 is an external light source that supplies light to the liquid crystal panel 11. The liquid crystal display device 10 further includes a pair of exterior components 15 and 16 that are front and rear components used in a pair to hold the liquid crystal panel 11 and the backlight unit 14 that are attached together. The exterior component 15 on the front has an opening 15a through which imaged displayed in the display area AA of the liquid crystal panel 11 are viewed from the outside. The liquid crystal display device 10 may be used in various kinds of electronic devices (not illustrated) such as mobile phones (including smartphones), notebook computers (including tablet computers), handheld terminals (including electronic books and PDAs), digital photo frames, portable video game players, and electronic-ink papers. The liquid crystal panel 11 in the liquid crystal display device 10 is in a range between some inches to ten and some inches . Namely, the liquid crystal panel 11 is in a size that is classified as a small or a small-to-medium.

The backlight unit 14 will be described. As illustrated in FIG. 2, the backlight unit 14 includes a chassis 14a, light sources (e.g., cold cathode fluorescent tubes, LEDs, organic ELs), an optical member. The chassis 14a has a box-like shape with an opening on the front (on a liquid crystal panel 11 side) . The light sources, which are not illustrated, are disposed inside the chassis 14a. The optical member, which is not illustrated, is disposed so as to cover the opening of the chassis 14a. The optical member has a function to convert light from the light sources into planar light.

Next, the liquid crystal panel 11 will be described. As illustrated in FIG. 1, the liquid crystal panel 11 has a vertically-long rectangular overall shape. The liquid crystal panel 11 includes the display area (an active area) AA that is off centered toward one of ends of a long dimension thereof (the upper side in FIG. 1). The driver 21 and the flexible printed circuit board 13 are mounted to the other end of the long dimension of the liquid crystal panel 11 (the lower side in FIG. 1). An area of the liquid crystal panel 11 outside the display area AA is a non-display area (non-active area) NAA in which images are not displayed. The non-display area NAA includes a frame-shaped area around the display area AA (a frame portion of a CF board 11a, which will be described later) and an area provided at the other end of the long dimension of the liquid crystal panel 11 (an exposed area of an array board 11b which does not overlap the CF board 11a and exposed, which will be described later). The area provided at the other end of the long dimension of the liquid crystal panel 11 includes a mounting area (an attachment area) to which the driver 21 and the flexible printed circuit board 13 are mounted. The non-display area NAA of the liquid crystal panel 11 has the frame-like shape. A width of each of three portions of the non-display area (non-mounting area portions) except for the mounting area to which the driver 21 and the flexible printed circuit board 13 are mounted corresponds to a linear distance between an outer edge of the glass substrate GS and an outer edge of the display area AA. The width is set equal to or smaller than 2. 0 mm, more preferably, equal to or smaller than 1.8 mm. Namely, the liquid crystal panel 11 has a narrow frame configuration in which a frame size is very small. A short-side direction and a long-side direction of the liquid crystal panel 11 correspond to the X-axis direction and the Y-axis direction in each drawing. In FIGS. 1, 5 and 6, a chain line box slightly smaller than the CF board 11a indicates a boundary of the display area AA. An area outside the chain line is the non-display area NAA.

Next, the components connected to the liquid crystal panel 11 will be described. As illustrated in FIGS. 1 and 2, the control circuit board 12 is mounted to the back surface of the chassis 14a (an outer surface on a side opposite from the liquid crystal panel 11) of the backlight unit 14 with screws. The control circuit board 12 includes a substrate and electronic components. The substrate is made of paper phenol or glass epoxy resin. The electronic components are mounted on the substrate and configured to supply various input signals to the driver 21. Traces (electrically conductive paths) which are not illustrated are formed in predetermined patterns. An end of the flexible printed circuit board 13 is electrically and mechanically connected to the control circuit board 12 via an anisotropic conductive film (ACF), which is not illustrated.

The flexible printed circuit board (an FPC board) 13 includes a base member made of synthetic resin having insulating property and flexibility (e.g., polyimide resin). A number of traces are formed on the base member (not illustrated). As illustrated in FIG. 2, the end of the long dimension of the flexible printed circuit board 13 is connected to the control circuit board 12 disposed on the back surface of the chassis 14a as described above. The other end of the long dimension of the flexible printed circuit board 13 is connected to the array board 11b in the liquid crystal panel 11. The flexible printed circuit board 13 is bent or folded back inside the liquid crystal display device 10 such that a cross-sectional shape thereof forms a U-like shape. At the ends of the long dimension of the flexible printed circuit board 13, portions of the traces are exposed to the outside and configured as terminals (not illustrated). The terminals are electrically connected to the control circuit board 12 and the liquid crystal panel 11. With this configuration, input singles supplied by the control circuit board 12 are transmitted to the liquid crystal panel 11.

As illustrated in FIG. 1, the driver 21 is an LSI chip including drive circuits. The driver 21 is configured to operate according to signals supplied by the control circuit board 12, which is a signal source, to process the input signal supplied by the control circuit board 12, to generate output signals, and to output the output signals to the display area AA in the liquid crystal panel 11. The driver 21 has a vertically-long rectangular shape (an elongated shape that extends along the short side of the liquid crystal panel 11) in a plan view. The driver 21 is directly mounted to the non-display area NAA of the liquid crystal panel 11 (or the array board 11b, which will be described later), that is, mounted by the chip-on-glass (COG) mounting method. A long-side direction and a short-side direction of the driver 21 correspond to the X-axis direction (the short-side direction of the liquid crystal panel 11) and the Y-axis direction (the long-side direction of the liquid crystal panel 11), respectively.

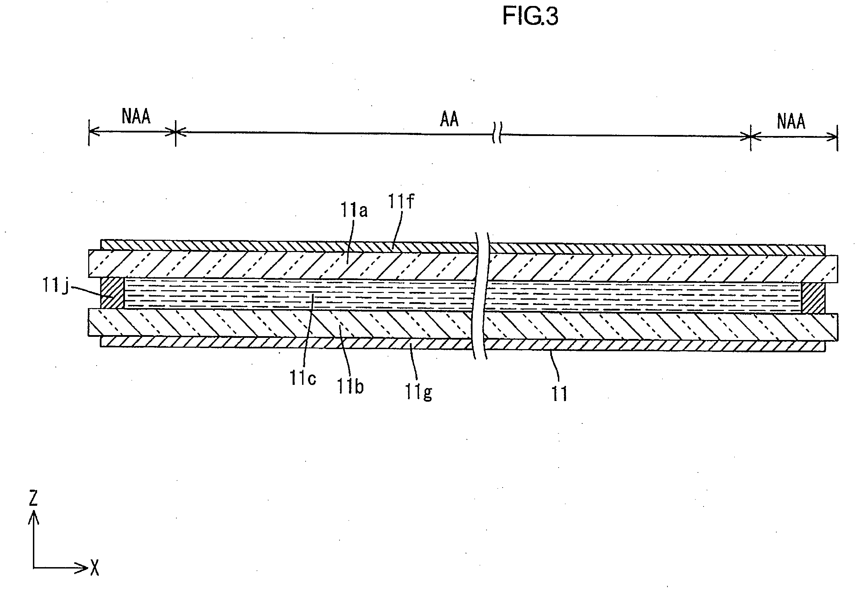

The liquid crystal panel 11 will be described in more detail. As illustrated in FIG. 3, the liquid crystal panel 11 includes at least a pair of substrates 11a and 11b, a liquid crystal layer (liquid crystals) 11c, and a sealing member 11j. The liquid crystal layer 11c is between the substrates 11a and 11b. The liquid crystal layer 11c includes liquid crystal molecules having optical characteristics that change according to application of electric field. The sealing member 11j is disposed between the substrates 11a, 11b to seal the liquid crystal layer 11c while a gap is maintained therebetween. A size of the gap corresponds to the thickness of the liquid crystal layer 11c. One of the substrates 11a, 11b on the front is the CF board (a counter substrate) 11a and one on the back (on the rear) is the array board (a substrate) 11b. The sealing member 11j is disposed in the non-display area NAA of the liquid crystal panel 11. The sealing member 11j has a vertically-long frame-like shape along the non-display area NAA in a plan view (viewed in the normal direction to a plate surface of the array board 11b) (FIG. 2). Portions of the sealing member 11j disposed in the three portions (the non-mounting area portions) of the liquid crystal panel 11 except for the mounting area are disposed at outermost positions in the non-display area NAA (FIG. 2). Polarizing plates 11f, 11g are attached to the outer surfaces of the substrates 11a, 11b.

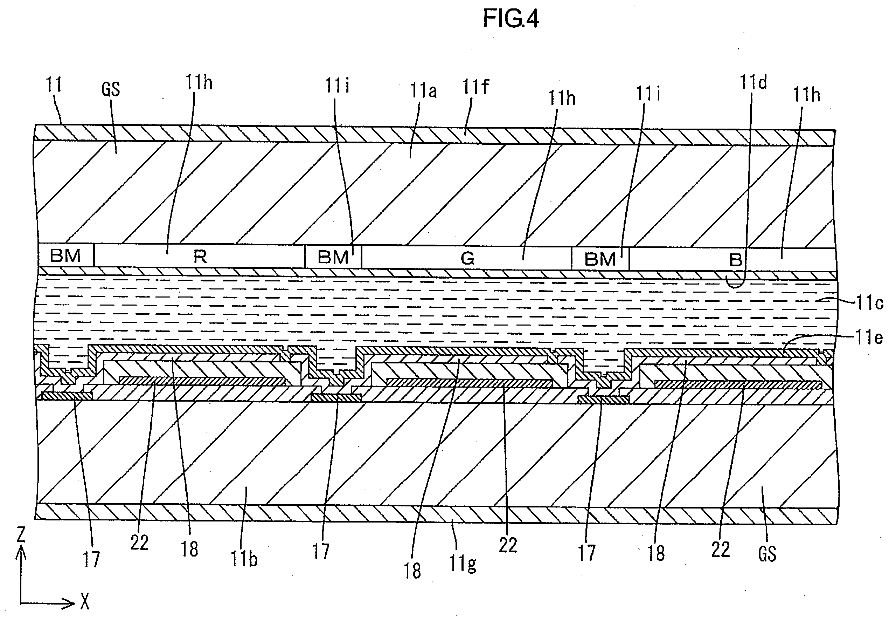

The liquid crystal panel 11 operates in fringe field switching (FFS) mode that is a mode improved from an in-plane switching (IPS) mode. As illustrated in FIG. 4, on one of the substrates 11a and 11b, specifically, on the array board 11b, pixel electrodes (second transparent electrodes) 18 and common electrodes (first transparent electrodes) 22, which will be described later, are formed. The pixel electrodes 18 and the common electrodes 22 are formed in different layers. The CF board 11a and the array board 11b includes glass substrates GS that are substantially transparent (i.e., having high light transmissivity). Various films are formed in layers on each glass substrate GS. As illustrated in FIGS. 1 and 2, the CF board 11a has a short dimension substantially equal to that of the array board 11b and a long dimension smaller than that of the array board 11b. The CF board 11a is bonded to the array board 11b with one of ends of the long dimension (the upper end in FIG. 1) aligned with a corresponding edge of the array board 11b. A predetermined area of the other end of the long dimension of the array board 11b (the lower end in FIG. 1) does not overlap the CF board 11a and front and back plate surfaces of the area are exposed to the outside. The mounting area in which the driver 21 and the flexible printed circuit board 13 are mounted is provided in this area. Alignment films 11d and 11e are formed on inner surfaces of the substrates 11a and 11b, respectively, for alignment of the liquid crystal molecules included in the liquid crystal layer 11c (FIG. 4).

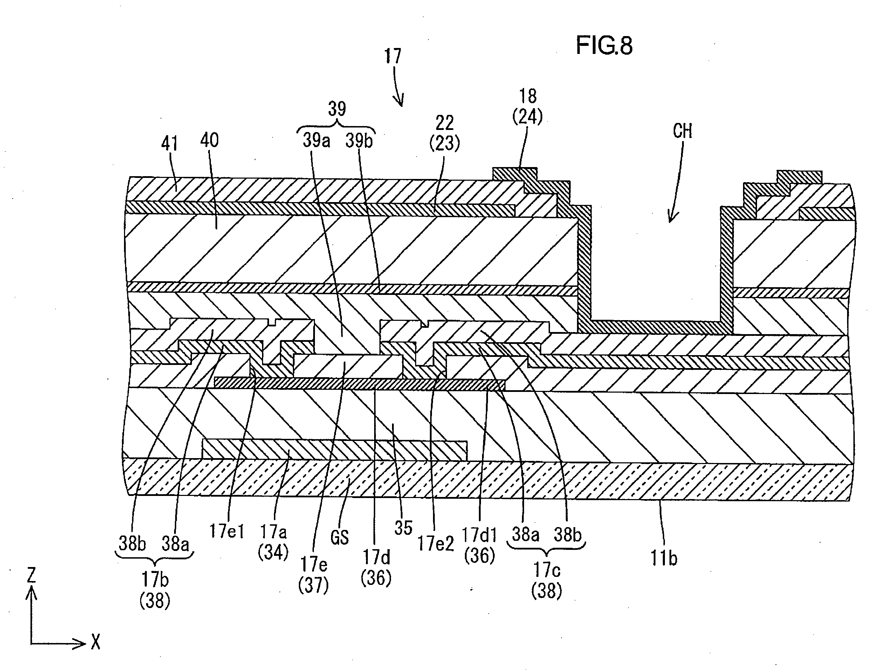

The films formed in layers on the inner surface of the array board 11b (on the liquid crystal layer 11c side, a surface opposite the CF board 11a) by a known photolithography method will be described. As illustrated in FIG. 8, on the array board 11b, the following films are formed in the following sequence from the lowest layer (the grass substrate GS): a first metal film (a gate metal film) 34, a gate insulator 35, an oxide semiconductor film 36, a protection film (an etching stopper film, an ES film) 37, a second metal film (a source metal film) 38, a first interlayer insulator (an insulator) 39, an organic insulator 40, a first transparent electrode film 23, a second interlayer insulator 41, and a second transparent electrode film 24.

The first metal film 34 is a single layer film of copper (Cu). In comparison to a configuration in which the first metal film 34 is a single layer film of aluminum (AL), a wiring resistance is lower and thus higher electrical conductivity is achieved. The gate insulator 35 is formed at least on the first metal film 34. The gate insulator 35 is made of silicon oxide (SiO₂). The oxide semiconductor film 36 is formed on the gate insulator 35. The oxide semiconductor film 36 is an oxide thin film that is a kind of oxide semiconductors containing indium (In), gallium (Ga), and zinc (Zn). The oxide semiconductor that contains indium (In), gallium (Ga), and zinc (Zn), that is, the oxide semiconductor film 36 may be amorphous or crystalline. In the display area AA, the oxide semiconductor film 36 forms first channels of display area TFTs 17, which will be described later. In the non-display area NAA, the oxide semiconductor film 36 forms second channels 29d of non-display area TFTs 29, which will be described later. The protection film 37 is formed at least on the oxide semiconductor film 36. The protection film 37 is made of silicon oxide (SiO₂).

The second metal film 38 is formed at least on the protection film 37. The second metal film 38 is a multilayer film that includes a lower metal film 38a containing titanium (Ti) and an upper metal film 38b contacting copper (Cu). In comparison to a configuration in which the second metal film is a multilayer film of titanium and aluminum (Al), the wiring resistance is lower and thus higher electrical conductivity is achieved. The first interlayer insulator 39 is formed on at least on the second metal film 38. The first interlayer insulator 39 has a multilayer structure including a lower first interlayer insulator (a lower insulator) 39a and an upper first interlayer insulator (an upper insulator) 39b. The lower first interlayer insulator 39a contains at least silicon and oxygen. The upper first interlayer insulator 39b contains at least silicon and nitrogen. The first interlayer insulator 39 will be described in more detail later. The organic insulator 40 is formed on the first interlayer insulator 39. The organic insulator 40 is made of acrylic resin (e.g., polymethyl methacrylate (PMMA)), which is an organic material, and functions as a planarization film.

The first transparent electrode film 23 is formed on the organic insulator 40. The first transparent electrode film 23 is made of transparent electrode material such as indium tin oxide (ITO) and zinc oxide (ZnO) . The second interlayer insulator 41 is formed at least on the first transparent electrode film 23. The second interlayer insulator 41 is made of silicon nitride (SiNx) . A pattern on the second interlayer insulator 41 in a plan view is equal to a pattern on the first interlayer insulator 39, which will be described in detail later. The second transparent electrode film 24 is formed at least on the second interlayer insulator 41. The second transparent electrode film 24 is made of transparent electrode material such as indium tin oxide (ITO) and zinc oxide (ZnO). The first transparent electrode film 23 and the second transparent electrode film 24 among the films are formed only in the display area AA of the array board 11b, that is, are not formed in the non-display area NAA. The insulators 35, 37, 39, 41 made of insulating materials including the gate insulator 35, the protection film 37, the first interlayer insulator 39, and the second interlayer insulator 41 are formed in solid patterns (although holes are formed in some areas) disposed in a whole area of the surface of the array board 11b. The first metal film 34, the oxide semiconductor film 36, and the second metal film 38 are formed in predetermined patterns in the display area AA and the non-display area NAA of the array board 11b.

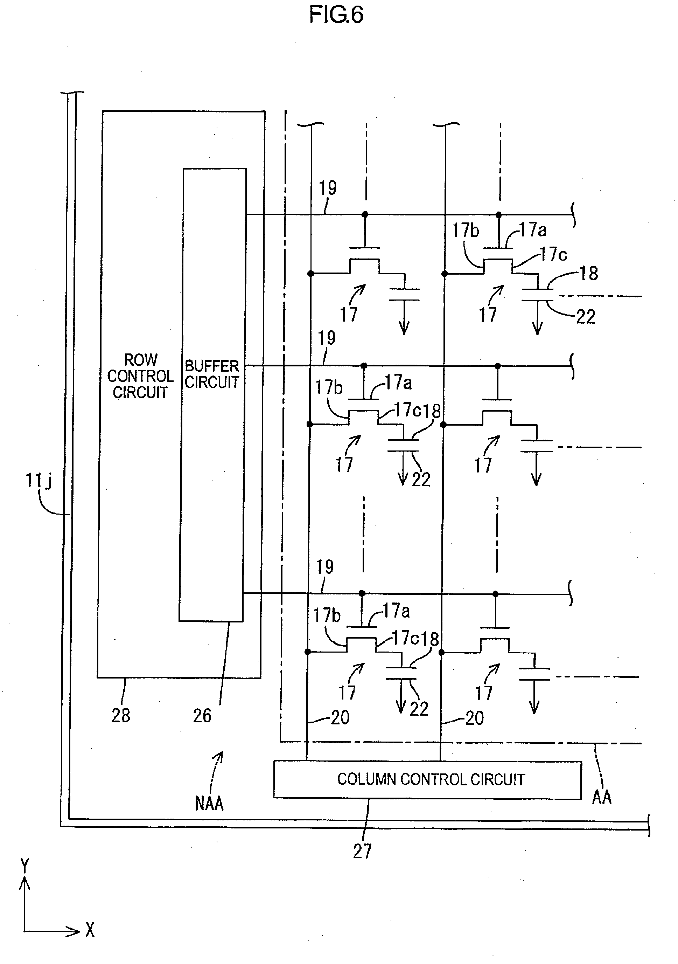

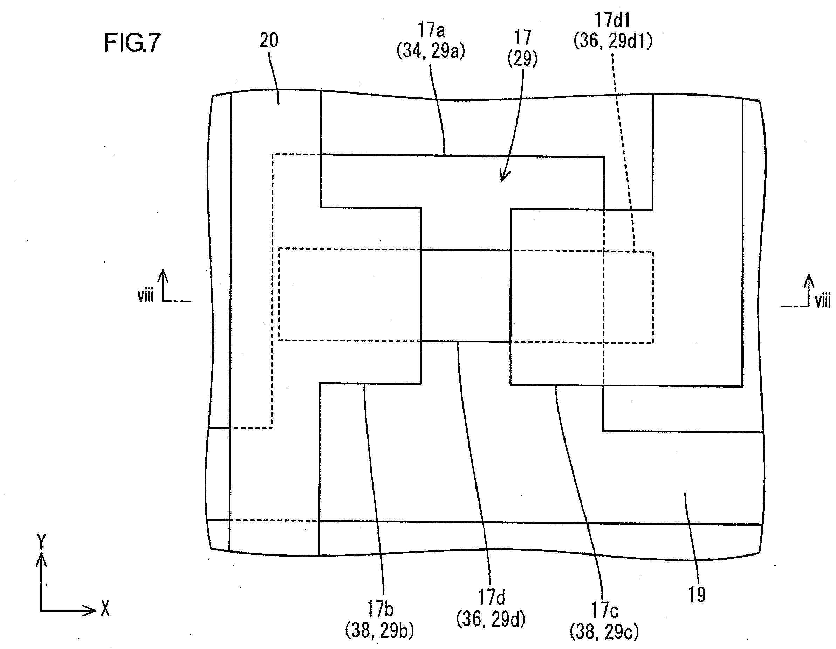

Next, configurations of components in the display area AA of the array board 11b will be described in sequence. As illustrated in FIGS. 6 and 7, in the display area AA of the array board 11b, the display area TFTs (display area transistors) 17, which are switching components, and pixel electrodes 18 are disposed in a matrix. Furthermore, gate lines (scanning lines, row control lines) 19 and source lines (column control lines, data lines) 20 are routed in a matrix such that each pair of display area TFT 17 and the pixel electrode 18 is in a cell defined by the gate lines 19 and the source lines 20. Namely, the display area TFTs 17 and the pixel electrodes 18 are disposed at respective corners defined by the gate lines 19 and the source lines 20 that are formed in a matrix such that they are arranged in a matrix. The gate lines 19 is formed from the first metal film 34 and the source lines 20 is formed from the second metal film 38. The gate insulator 35 and the protection film 37 are disposed between the gate line 19 and the source line 20 at an intersection thereof. The gate lines 19 and the source lines 20 are connected to first gate electrodes 17a and first source electrodes 17b of the respective display area TFTs 17, respectively. The pixel electrodes 18 are connected to first drain electrodes 17c of the display area TFTs 17, respectively (FIG. 8). As illustrated in FIG. 7, each first gate electrode 17a corresponds to a portion that is branched off the corresponding gate line 19 that linearly extends in the X-axis direction. The first gate electrode 17a projects from the gate line 19 in the Y-axis direction. Each first source electrode 17b is branched off the corresponding source line 20 that linearly extends in the Y-axis direction. The first source electrode 17b projects from the source line 20 in the X-axis direction.

As illustrated in FIG. 8, each display area TFT 17 includes the first gate electrode 17a, a first channel 17d, a first protection portion 17e, the first source electrode 17b, and the first drain electrode 17c. The first gate electrode 17a is formed from the first metal film 34. The first channel 17d is formed from the oxide semiconductor film 36 and disposed so as to overlap the first gate electrode 17a in a plan view. The first protection portion 17e is formed from the protection film 37. The first protection portion 17e includes two first holes 17e1 and 17e2 that are through holes formed at positions overlapping the first channel 17d in a plan view. The first source electrode 17b is formed from the second metal film 38 and connected to the first channel 17d via one of the first through holes 17e1 and 17e2, specifically the through hole 17e2. The first drain electrode 17c is formed from the second metal film 38 and connected to the first channel 17d via the other one of the first through holes 17e1 and 17e2, specifically the through hole 17e2. The first channel 17d bridges the first source electrode 17b and-the first drain electrode 17c to allow a flow of electric charge between the electrodes 17b and 17c. The first source electrode 17b and the first drain electrode 17c are disposed opposite to each other in a direction in which the first channel 17d extends (the X-axis direction) with a predetermined gap therebetween.

As illustrated in FIG. 7, the first gate electrode 17a is branched off the gate line 19. The area in which the first gate electrode 17a is formed overlaps about an entire area of the first source electrode 17b and a portion of the first drain electrode 17c (a portion connected with the first channel 17d and therearound) in a plan view. In comparison to a configuration in which the first gate electrode overlaps about an entire area of the first drain electrode 17c in a plan view, parasitic capacitance (hereinafter referred to as Cgd capacitance) among the first gate electrode 17a, the first source electrode 17b, the first drain electrode 17c, and the first channel 17d can be reduced. Therefore, a percentage of the Cgd capacitance in a total capacitance of the display pixel decreases. The Cgd capacitance is less likely to affect a voltage applied to the pixel electrode 18. This configuration is preferable for the liquid crystal panel 11, the definition of which is enhanced and an area of the display pixel and the total capacity are decreased. Because the area in which the first gate electrode 17a is defined as described above, the first channel 17d is configured as follows. As illustrated in FIGS. 7 and 8, the first channel 17d includes a first extending portion 17d1 that extends from a portion connected to the first drain electrode 17c in the X-axis direction toward a side opposite from the first source electrode 17b (toward the right in FIGS. 7 and 8). The first extending portion 17d1 includes an end (a portion) which does not overlap the first gate electrode 17a in a plan view. The oxide semiconductor film 36 that forms the first channel 17d has electron mobility higher than that of an amorphous silicon film, for example, 20 to 50 times higher. Therefore, the display area TFTs 17 can be easily downsized and an amount of transmitted light through each pixel electrode 18 can be increased to a maximum level. This configuration is preferable for enhancement of image resolution and reduction of power consumption. Each display area TFT 17 including the first channel 17d formed from the oxide semiconductor film 36 is an inverted-staggered type having a configuration in which the first gate electrode 17a is disposed at the bottom and the first channel 17d is disposed thereon via the gate insulator 35. A stacking structure of the display area TFT 17 is similar to that of a commonly-used TFT including an amorphous silicon thin film.

Each pixel electrode 18 is formed from the second transparent electrode film 24. The pixel electrode 18 has a vertically-long rectangular overall shape in a plan view and disposed in an area defined by the gate lines 19 and the source lines 20. The pixel electrode 18 includes longitudinal slits (not illustrated), with which a comb-shaped portion is formed. As illustrated in FIG. 8, the pixel electrode 18 is formed on the second interlayer insulator 41. The second interlayer insulator 41 is between the pixel electrode 18 and a common electrode 22, which will be described later. Under the pixel electrode 18, the first interlayer insulator 39, the organic insulator 40, and the second interlayer insulator 41 are disposed. Portions of those overlapping the first drain electrode 17c in a plan view include contact holes CH that are through holes running from the top to the bottom. The pixel electrode 18 is connected to the first drain electrode 17c of the display area TFT 17 via the contact holes CH. When a voltage is applied to the first gate electrode 17a of the display area TFT 17, a current flows between the first source electrode 17b and the first drain electrode 17c via the first channel 17d. As a result, a predetermined potential is applied to the pixel electrode 18. The contact holes CH are arranged at a position that does not overlap the first gate electrode 17a and the first channel 17d formed from the oxide semiconductor layer 36 in a plan view. During formation of the second interlayer insulator 41, holes are formed in the second interlayer insulator 41 by patterning using a mask. The first interlayer insulator 39 and the organic insulator 40 are etched using the second interlayer insulator 41 including the holes as a resist. As a result, holes that continue to the hole of the second interlayer insulator 41 are formed in the first interlayer insulator 39 and the organic insulator 40.

The common electrode 22 is formed from the first transparent electrode film 23. The common electrode 22 is a solid trace formed in a substantially whole area of the display area AA of the array board 11b. As illustrated in FIG. 8, the common electrode 22 is sandwiched between the organic insulator 40 and the second interlayer insulator 41. A common potential (a reference potential) is applied to the common electrode 22 through a common line, which is not illustrated. By controlling the potential applied to the pixel electrode by the display area TFT 17 as described above, a predetermined potential difference occurs between the electrodes 18 and 22. When a potential difference occurs between the electrodes 18 and 22, a fringe field (an oblique field) including a component in a direction normal to a plate surface of the array board 11b is applied to the liquid crystal layer 11c in addition to a component in a direction along the plate surface of the array board 11b because of the slits 18a of the pixel electrode 18. Therefore, not only alignment of the liquid crystal molecules in the slits 18a in the liquid crystal layer 11c but also alignment of the liquid crystal molecules on the pixel electrode 18 is properly switchable. With this configuration, the aperture ratio of a liquid crystal panel 11 increases and a sufficient amount of transmitted light is obtained. Furthermore, high view-angle performance is achieved. Capacitor lines may be provided (not illustrated). The capacitor lines may extend parallel to the gate lines 19, and may cross and overlap the gate lines 19 via the pixel electrodes 18, and overlap the gate insulator 35, the protection film 37, the first interlayer insulator 39, the organic insulator 40, and the second insulator 41.

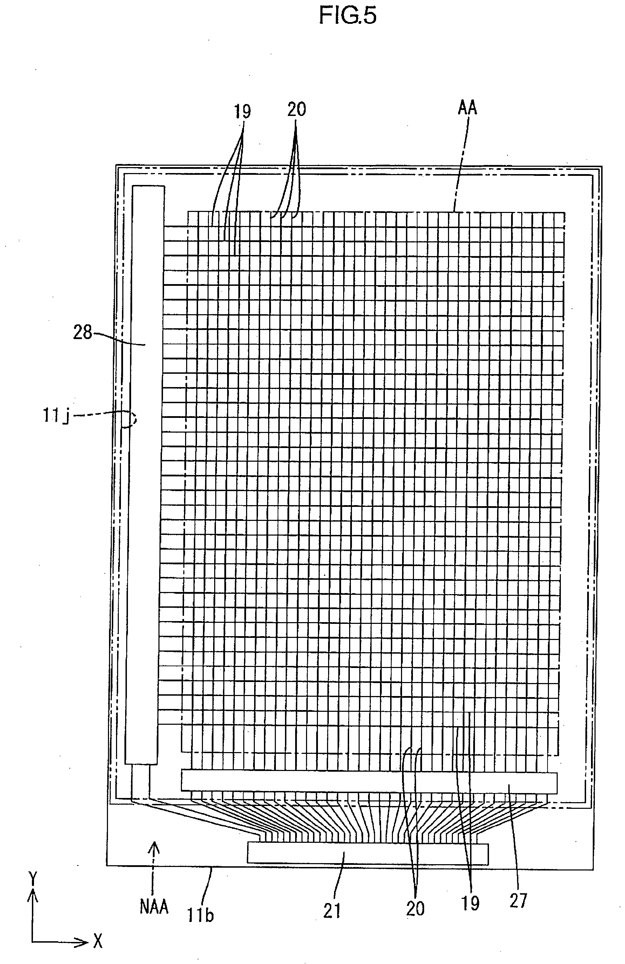

Next, configurations of components in the display area AA of the CF board 11a will be described in detail. As illustrated in FIG. 4, the CF board 11a includes color filters 11h including red (R), green (G), and blue (B) color portions arranged in a matrix so as to overlap the pixel electrodes 18 on the array board 11b in a plan view. A light blocking layer (a black matrix) 11i is formed in a grid for colors from mixing. Each line of the grid is located between the adjacent color portions of the color filters 11h. The light blocking layer 11i is disposed over the gate lines 19 and the source lines 20 in a plan view. An alignment film 11d is formed on the surfaces of the color filters 11h and the light blocking layer 11i. Each display pixel of the liquid crystal panel 11 includes three color portions, that is, R (red), G (green) and B (blue) color portions and three pixel electrodes 18 opposite the color portions, respectively. The display pixel includes a red pixel including the R color portion, a green pixel including the G color portion, and a blue pixel including the B color portion. The pixels are arranged on the plate surface of the liquid crystal panel 11 in repeated sequence along the row direction (the X-axis direction) and form groups of pixels. The groups of pixels are arranged along the column direction (the Y-axis direction) (FIGS. 4 and 5).

Next, configurations of components in the non-display area NAA of the array board 11b will be described in detail. As illustrated in FIG. 5, a column control circuit 27 is disposed in a portion of the non-display area NAA of the array board 11b adjacent to the short edge of the display area AA. A row control circuit 28 is disposed in a portion of the non-display area NAA adjacent to the long edge of the display area AA. The column control circuit 27 and the row control circuit 28 are configured to perform control for supplying output signals from the driver 21 to the display area TFTs 17. The column control circuit 27 and the row control circuit 28 are monolithically fabricated on the array board 11b with the oxide semiconductor film 36 as a base, which is similar to the display area TFT 17. The column control circuit 27 and the row control circuit 28 include control circuits configure to perform control for supplying the output signals to the display area TFTs 17. As illustrated in FIGS. 5 and 6, the column control circuit 27 and the row control circuit 28 are disposed inner than the sealing member 11j in the non-display area NAA, that is, closer to the display area AA. The column control circuit 27 and the row control circuit 28 are closer to the seating member 11j than the display area TFTs 17. In FIG. 5, the sealing member 11j is indicated by a two-dashed chain line. In FIG. 6, the sealing member 11j is indicated by a solid line. The column control circuit 27 and the row control circuit 28 are formed on the array board 11b by patterning using a known photolithography method during patterning of the display area TFTs 17 in the fabrication process of the array board 11b.

As illustrated in FIG. 5, the column control circuit 27 is disposed adjacent to the short edge of the display area AA located at the lower side in FIG. 5. Namely, the column control circuit 27 is disposed in a horizontally-long rectangular area along the X-axis direction between the display area AA and the driver 21 with respect to the Y-axis direction. The column control circuit 27 is connected to the source lines 20 in the display area AA. The column control circuit 27 includes switching circuit (RGB switching circuit) configured to sort image signals in the output signals from the driver 21 to the respective source lines 20. The source lines 20 are disposed in the display area AA of the array board 11b along the X-axis direction and parallel to each other. The source lines 20 are connected to the display area TFTs 17 that form R (red), G (green) and B (blue) pixels, respectively. The column control circuit 27 sorts the image signals from the driver 21 using the switching circuit and supplies the sorted signals to the respective R, G, B source lines 20. The column control circuit 27 may include ancillary circuits such as a level-shifter circuit and ESD protection circuit.

As illustrated in FIG. 5, the row control circuit 28 is disposed adjacent to the long edge of the display area AA on the left in FIG. 5 within a vertically-long area that extends in the Y-axis direction. The row control circuit 28 is connected to the gate lines 19 in the display area AA. The row control circuit 28 includes a scanning circuit configured to supply scan signals included in the output signals from the driver 21 to the gate lines 19 at the predetermined timing to scan the gate lines 19 in sequence. The gate lines 19 are disposed in the display area AA of the array board 11b along the Y-axis direction and parallel to each other. The row control circuit 28 supplies control signals (the scan signals) from the driver 21 using the scanning circuit to the gate lines 19 in sequence from the one at the top in FIG. 5 to the one at the bottom to scan the gate lines 19. The row control circuit 28 may include ancillary circuits such as a level-shifter circuit and ESD protection circuit. The column control circuit 27 and the row control circuit 28 are connected to the driver 21 via traces formed on the array board 11b, which are not illustrated.

As illustrated in FIG. 5, the scanning circuit in the row control circuit 28 includes a buffer circuit 26 connected to the gate lines 19 and configured to output scan signals to the gate lines 19 after amplify the scan signals. The buffer circuit 26 includes non-display area TFTs (non-display area transistors) 29. The non-display area TFTs 29 are disposed in the non-display area NAA on the plate surface of the array board 11b. The non-display area TFTs 29 are formed at the same time when the display area TFTs 17 are formed in the fabrication process of the array board 11b. The non-display area TFTs 29 are for outputting the scan signals at the final stage of signal processing performed by the scanning circuit. Therefore, the current handled by the non-display area TFTs 29 is larger than the current handled by the display area TFTs 17.

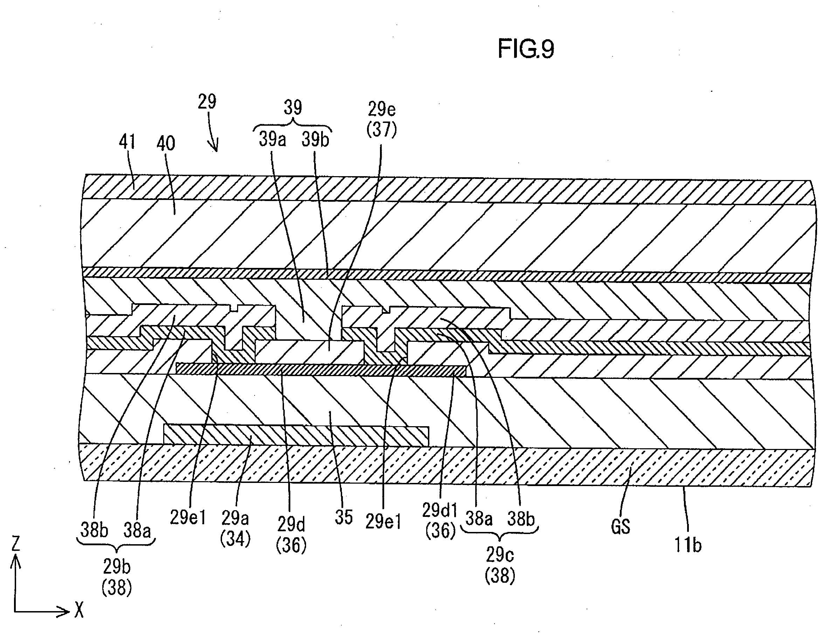

A stacking structure of each non-display area TFT 29 will be described. As illustrated in FIG. 9, the non-display area TFT 29 includes a second gate electrode (a gate electrode) 29a, a second channel 29d, a second protection portion 29e, a second source electrode (a source electrode) 29b, and a second drain electrode (a drain electrode) 29c. The second gate electrode 29a is formed from the first metal film 34. The second channel 29d is formed from the oxide semiconductor film 36. The second channel 29d is arranged so as to overlap the second gate electrode 29a in a plan view. The second protection portion 29e is formed from the protection film 37. The second protection portion 29e includes two holes 29e1 and 29e2 that are through holes formed at positions that overlap the second channel 29d in a plan view. The second source electrode 29b is formed from the second metal film 38. The second source electrode 29b is connected to the second channel 29d via one of the second holes 29e1 and 29e2, specifically, the second hole 29e1. The second drain electrode 29c is formed from the second metal film 38. The second drain electrode 29c is connected to the second channel 29d via the other one of the holes 29e1 and 29e2, specifically, the second hole 29e2 . The second channel 29d extends in the X-axis direction and bridges the second source electrode 29b and the second drain electrode 29c to allow a flow of electric charge between the electrodes 29b and 29c. The second source electrode 29b and the second drain electrode 29c are opposite to each other with a predetermined distance therebetween with respect to a direction in which the second channel 29d extends (the X-axis direction).

The arrangement of the second gate electrode 29a, the second source electrode 29b, the second drain electrode 29c, the second channel 29d, and the second protection portion 29e of each non-display area TFT 29 in a plan view is similar to those of each display area TFT 17 described earlier and as illustrated in FIG. 7. As illustrated in FIG. 7, the second gate electrode 29a is a portion that is branched off the corresponding gate line 19, similar to the first gate electrode 17a in the display area TFT 17. An area in which the second gate electrode 29a is formed overlaps about an entire area of the second source electrode 29b and a portion of the second drain electrode 29c (a portion connected with the second channel 29d and therearound) in a plan view. Because the area in which the second gate electrode 29a is defined as described above, the second channel 29d is configured as follows . As illustrated in FIGS. 7 and 9, the second channel 29d includes a second extending portion an extending portion) 29d1 that extends from a portion connected to the second drain electrode 29c in the X-axis direction toward a side opposite from the second source electrode 29b (toward the right in FIG. 9). The second extending portion 29d1 includes an end (a portion) which does not overlap the second gate electrode 29a in a plan view. The oxide semiconductor film 36 that forms the second channel 29d has a configuration similar to that of the first channel 17d in the display area TFT 17 and has high electron mobility. Furthermore, similar to the display area TFT 17, the non-display area TFT 29 is an inverted-staggered type having a configuration in which the second gate electrode 29a is disposed at the bottom and the second channel 29d is arranged thereon via the gate insulator 35. The configurations of the components of the non-display area TFT 29 similar to those of the components of the display area TFT 17 are preferable for enhancing yield.

As illustrated in FIGS. 4 and 5, the non-display area TFTs 29 disposed in the non-display area NAA are outer than and closer to the seating member 11j than the display area TFTs 17 disposed in the display area AA on the array board 11b. If moisture permeates the sealing member 11j from the outside to the inside, the non-display area TFTs 29 are subject to the moisture. If the moisture is taken into the second channels 29d formed from the oxide semiconductor film 36 in the non-display area TFTs 29 and the second channels 29d deteriorate, the electrical characteristics of the second channels 29d may change and thus malfunctions of the non-display area TFTs 29 may occur. Furthermore, the non-display area TFTs 29 are components of the buffer circuit 26 in the row control circuit 28. The currents fed to the non-display area TFTs 29 are larger than the currents fed to the display area TFTs 17. Therefore, the malfunctions of the non-display area TFTs 29 due to the change in the electrical characteristics are more likely to cause display defects in the liquid crystal panel 11. Furthermore, as described earlier, the second channel 29d in each non-display area TFT 29 includes the second extending portion (an extending portion) 29d, a portion of which does not overlap the second gate electrode 29a as illustrated in FIGS. 7 and 9. The extending portion 29d1 is subject to irradiation of light because light from the backlight unit 14 to the liquid crystal panel 11 is less likely to be blocked by the second gate electrode 29a. The oxide semiconductor film 36 that forms the second channels 29d has characteristics that the flow of electric charge tends to be easily affected by energy of light. During driving of the non-display area TFT 29, electric charge may build up in the second extending portion 29d1. Such a problem tends to result in a malfunction of the non-display TFT 29 together with the problem that the oxide semiconductor film 36 deteriorates caused by the moisture taken into the oxide semiconductor film 36.

On the array board 11b according to this embodiment, each first interlayer insulator 39 that covers the second source electrode 29b, the second drain electrode 29c, and the second channel 29d in each non-display area TFT 29 from above has a multilayer structure including the lower first interlayer insulator 39a and the upper first interlayer insulator 39b. The lower first interlayer insulator 39a is disposed in the lower layer between the two. The lower first interlayer insulator 39a contains at least silicon and oxygen. The upper first interlayer insulator 39b is disposed in the upper layer between the two. The upper first interlayer insulator 39b contains at least silicon and nitrogen. With this configuration, the following functions and effects are achieved. The upper first interlayer insulator 39b of the first interlayer insulator 39 disposed in the upper layer contains at least silicon and nitrogen. Even if moisture enters into the non-display area TFT 29 from the outside because it is disposed closer to the sealing member 11j, the moisture is less likely to permeate the upper first interlayer insulator 39b. Therefore, the moisture is less likely to reach the second channel 29d formed from the oxide semiconductor film 36. The upper first interlayer insulator 39b contains silicon and nitrogen. During the formation of the upper first interlayer insulator 39b, hydrogen is generated in a process of forming the film by reaction of silane (SiH₄) and ammonia (NH₃). Namely, the upper first interlayer insulator 39b may take the moisture therein and the hydrogen may be desorbed depending on a thermal environment after the formation of the film. Even in such a case, because the lower first interlayer insulator 39a of the first interlayer insulator 39 disposed in the lower layer contains at least the silicon and the oxygen, the hydrogen desorbed from the upper first interlayer insulator 39b is less likely to permeate the lower first interlayer insulator 39a. Therefore, the desorbed hydrogen is less likely to reach the second channel 29d formed from the oxide semiconductor film 36. The second channel 29d formed from the oxide semiconductor film 36 is less likely to deteriorate due to the moisture taken into the second channel 29d and the electrical characteristics are less likely to change. Therefore, the malfunction of the non-display area TFT 29 is less likely to occur.

The upper first interlayer insulator 39b of the first interlayer insulator 39 according to this embodiment has a thickness in a range from 35 nm to 75 nm. Therefore, the amount of hydrogen desorbed from the upper first interlayer insulator 39b is reduced and a sufficient level of moisture resistance of the upper first interlayer insulator 39b is achieved. The electrical characteristics of the second channel 29d formed from the oxide semiconductor film 36 are less likely to change and thus the non-display area TFT 29 is less likely to cause a malfunction. Because the non-display area TFT 29 is less likely to cause the malfunction, proper operation of the buffer circuit 26 is ensured. The liquid crystal panel 11 is less likely to have display defects and has high operation reliability. The second channel 29d of the non-display area TFT 29 includes the second extending portion 29d1 that is subject to irradiation of light. According to this configuration, a malfunction of the second channel 29d tends to occur. However, the malfunctions due to the moisture from the outside are less likely to occur as described above. Therefore, a sufficient level of the operation reliability is ensured. Furthermore, the protection film 37 (the second protection portion 29e) made of silicon oxide is disposed between the second source electrode 29b and the second channel 29d and the second drain electrode 29c and the second channel 29d. According to this configuration, the amount of hydrogen desorbed from the protection film 37 is reduced and thus the second channel 29d is less likely to take the hydrogen therein. Therefore, the malfunction of the non-display TFT 29 is less likely to occur. The second source electrode 29b and the second drain electrode 29c contain cupper and thus corrosion tends to occur due to the moisture. However, because permeation of the moisture is restricted by the upper first interlayer insulator 39b, the corrosion is reduced and thus the malfunction of the non-display area TFT 29 is less likely to occur. The lower first interlayer insulator 39a has a thickness larger than that of the upper first interlayer insulator 39b.

Compositions of the lower first interlayer insulator 39a and the upper first interlayer insulator 39b will be described in detail. The lower first interlayer insulator 39a may be made of silicon oxide (SiO₂) . The upper first interlayer insulator 39b may be made of silicon nitride (SiNx). The composition of the upper first interlayer insulator 39b is hot limited to that contains only the silicon and the nitrogen. The composition may include other elements (oxygen). The upper first interlayer insulator 39b is configured such that a refractive index thereof varies according to a content of nitrogen. The refractive index tends to become smaller as the content of nitrogen decreases, and the refractive index tends to become larger as the content of nitrogen increases. Specifically, the composition of the upper first interlayer insulator 39b becomes closer to that of pure silicon nitride as the refractive index becomes closer to 2.0. The content of nitrogen decreases and a content of oxygen increases as the refractive index becomes farther from 2.0. Similarly, the composition of the lower first interlayer insulator 39a is not limited to that includes only silicon and oxygen. The composition may include elements other than the silicon and the oxygen (e.g., nitrogen). If the composition includes the nitrogen, the lower first interlayer insulator 39a has a relationship between the refractive index and the content of nitrogen similar to that in the upper first interlayer insulator 39b. The refractive index of the upper first interlayer insulator 39b according to this embodiment is in a range from 1.5 to 1.9. With this configuration, a sufficient level of moisture resistance is achieved and thus the electrical characteristics of the second channel 29d formed from the oxide semiconductor film 36 are less likely to change. Furthermore, the formation of the film is easily performed by general fabrication equipment. The refractive index of the upper first interlayer insulator 39b according to this embodiment is in a range from 1.5 to 1.72. With this configuration, a content of hydrogen in the upper first interlayer insulator 39b further decreases and thus the content of hydrogen desorbed from the upper first interlayer insulator 39b decreases. Therefore, the electrical characteristics of the second channel 29d formed from the oxide semiconductor film 36 are less likely to change due to the desorbed hydrogen.

The ranges of the thickness and the refractive index of the upper first interlayer insulator 39b in each non-display area TFT 29 included in the buffer circuit 26 have been described. The upper first interlayer insulators 39b are formed from the same material and with substantially even thickness for the entire surface of the array board 11b. The ranges of thicknesses and refractive indexes of the upper first interlayer insulators 39b in each non-display area TFT 29 in a circuit other than the buffer circuit 26 and in each display area TFT 17 in the display area AA are defined similar to the non-display area TFT 29 in the buffer circuit 26. Therefore, the same functions and effects are achieved.

### <Comparative Experiments>

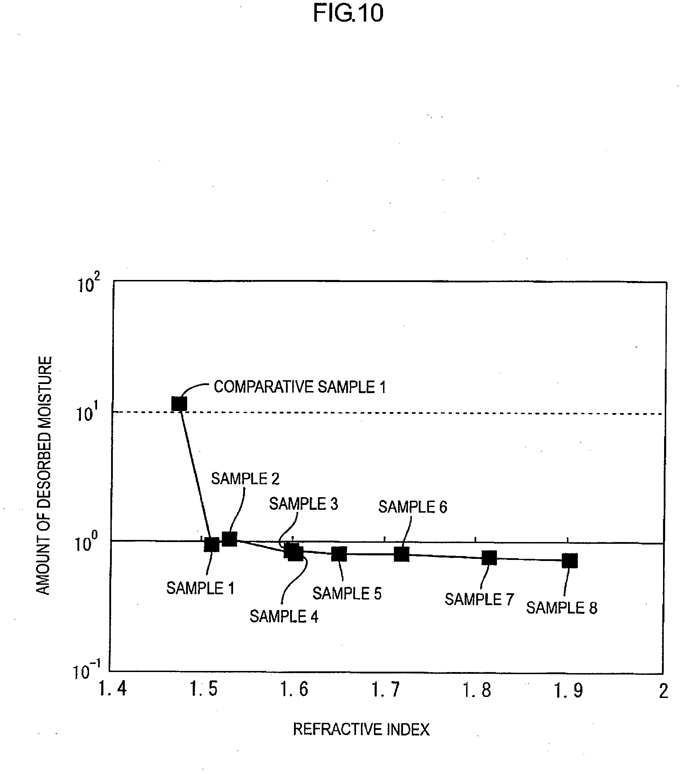

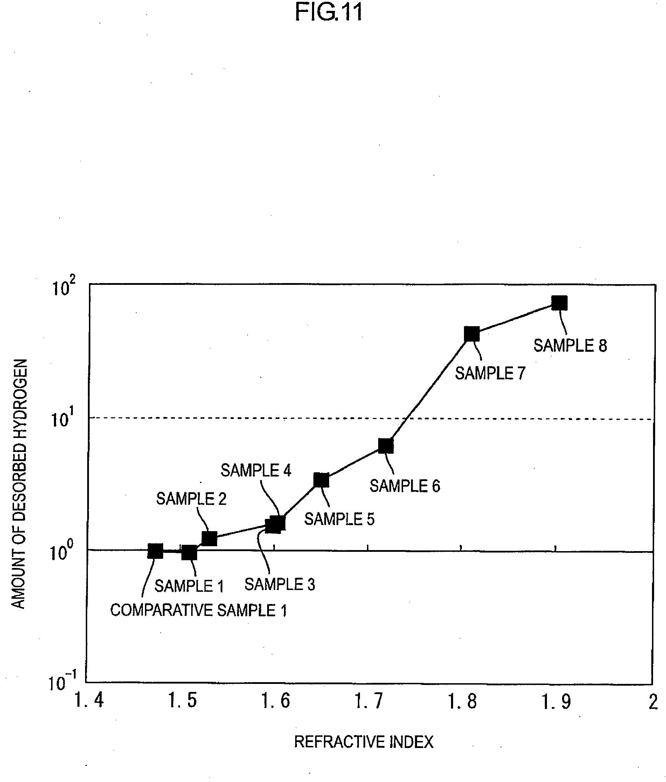

The thickness of the upper first interlayer insulator 39b is set in the range from 35 nm to 75 nm and the refractive index thereof is set in the range from 1.5 to 1.9, more preferably, from 1.5 to 1.73 in this embodiment based on results of comparative experiments 1 to 3. The comparative experiments 1 to 3 will be described. In comparative experiment 1, the refractive index of the upper first interlayer insulator 39b of the first interlayer insulator 39 in each non-display area TFT 29 was varied in a range from 1.475 to 1.9. Furthermore, amounts of desorbed moisture and desorbed hydrogen per one nm of thickness of the upper first interlayer insulator 39b were measured through thermal disportion spectroscopy (TDS). In comparative experiment 1, a comparative sample 1 including the upper first interlayer insulator 39b having a refractive index set to 1.475 was used. Furthermore, samples having the following refractive indexes were used. The refractive index was set to 1.51 in sample 1. The refractive index was set to 1.51 in sample 1. The refractive index was set to 1.53 in sample 2. The refractive index was set to 1.6 in sample 3. The refractive index was set to 1.60 in sample 4. The refractive index was set to 1.65 in sample 5. The refractive index was set to 1.72 in sample 6. The refractive index was set to 1.815 in sample 7. The refractive index was set to 1.9 in sample 8. FIGS. 10 and 11 illustrate the measurements in the comparative experiment 1. In FIG. 10, the horizontal axis indicates the refractive index of the upper first interlayer insulator 39b and the vertical axis indicates the amount of moisture desorbed from the upper first interlayer insulator 39b. In FIG. 11, the horizontal axis indicates the refractive index of the upper first interlayer insulator 39b and the vertical axis indicates the amount of hydrogen desorbed from the upper first interlayer insulator 39b. The amount of desorbed moisture or the amount of desorbed hydrogen in FIG. 10 or 11 corresponds to the number of desorbed molecules desorbed per thickness of 1 nm of the upper first interlayer insulator 39b expressed relative to the number of desorbed molecules of sample 1, which is defined as a reference (1.0).

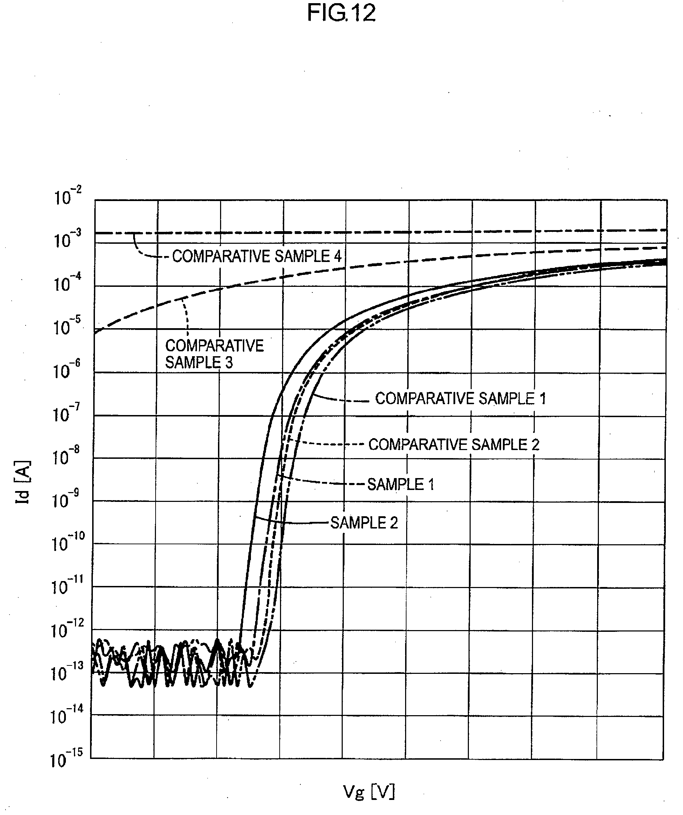

In comparative experiment 2, the thickness of the upper first interlayer insulator 39b of the first interlayer insulator 39 in the non-display area TFT 29 was varied in a range from 0 nm to 100 nm and current-voltage characteristics of the non-display area TFT 29 were measured. Specifically, in comparative experiment 2, the thickness of the upper first interlayer insulator 39b was set to 0 nm in comparative sample 1. The thickness was set to 25 nm in comparative sample 2. The thickness was set to 50 nm in sample 1. The thickness was set to 75 nm in sample 2. The thickness was set to 85 nm in comparative sample 3. The thickness was set to 100 nm in comparative sample 4. In comparative sample 1, the upper first interlayer insulator 39b was removed from the first interlayer insulator 39, that is, the first interlayer insulator 39 included only the lower first interlayer insulator 39a. In the comparative samples and the samples in comparative experiment 2, the thicknesses of the lower first interlayer insulators 39a were all set to 265 nm. FIG. 12 illustrates the measurements in comparative experiment 2. In FIG. 12, the horizontal axis indicates a voltage applied to the second gate electrode 29a (in volts [V]). The horizontal axis indicates a current that flows between the second source electrode 29b and the drain electrode 29c (in amperes [A]). In FIG. 12, a curve of comparative sample 1 is indicated by a two-dashed chain line. A curve of comparative sample 2 is indicated by a narrowly spaced broken line. A curve of sample 1 is indicated by a thick dashed chain line. A curve of sample 2 is indicated by a solid line. A curve of comparative sample 3 is indicated by a widely spaced broken line. A curve of comparative sample 4 is indicated by a narrowly spaced dashed chain line.

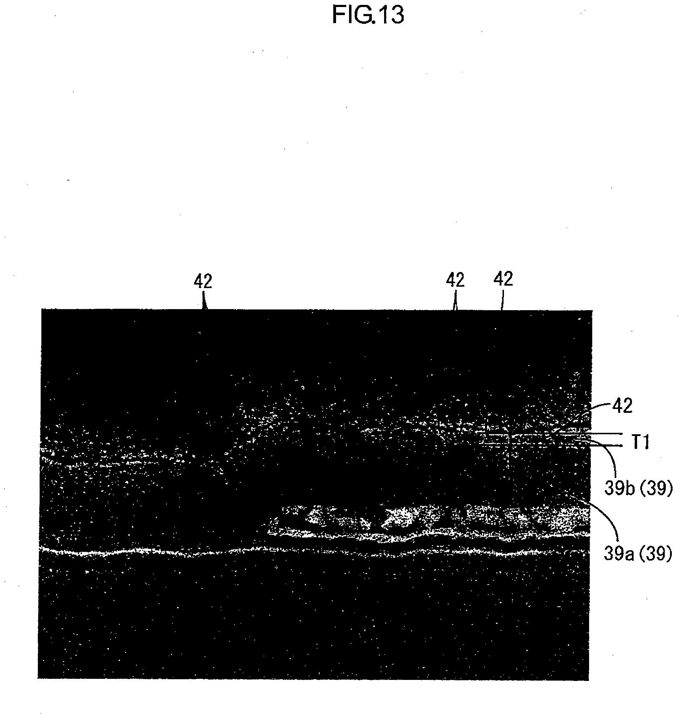

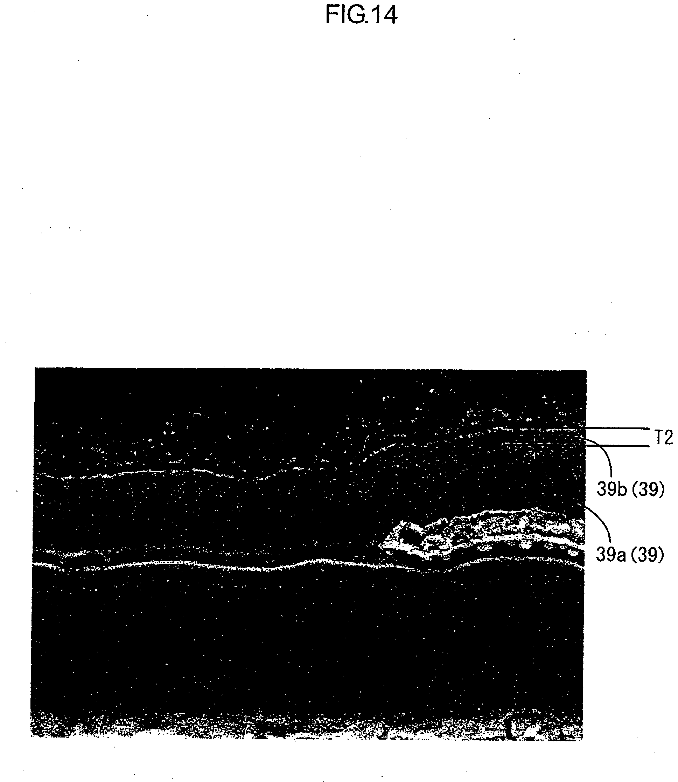

In comparative experiment 3, the thickness of the upper first interlayer insulator 39b of the first interlayer insulator 39 in the non-display area TFT 29 was varied and images of cross-sectional configurations were captured by an electron microscope such as a scanning electron microscope (SEM). Specifically, in comparative experiment 2, the thickness T1 of the upper first interlayer insulator 39b in comparative sample 1 was set to 25 nm. In sample 1, the thickness T2 is set to 35 nm. In comparative sample 1 and sample 1 in comparative experiment 3, the thicknesses of the lower first interlayer insulators 39a were all set to 150 nm. The images captured in comparative experiment 3 are provided in FIGS. 13 and 14. FIGS 13 and 14 are cross-sectional images of the non-display area TFT 29 cut along the X-axis direction at the midpoint of the Y-axis dimension. FIG. 13 is a picture of comparative sample 1 and FIG. 14 is a picture of sample 1.

Next, results of the comparative experiments will be described. Regarding comparative experiment 1, FIG. 10 illustrates that the amount of desorbed moisture in comparative sample 1 is significantly large in comparison to those in samples 1 to 8. This may be because the amount of nitrogen in the upper first interlayer insulator 39b becomes significantly small when the refractive index of the upper first interlayer insulator 39b is lower than 1.5 and the moisture resistance decreases resulting in an increase in moisture permeability. In samples 1 to 8, the refractive indexes of the upper first interlayer insulators 39b are equal to or larger than 1.5. Therefore, the amounts of desorbed moisture are small, that is, they have sufficient moisture resistance. It is preferable to set the lower limit of the refractive index of the upper first interlayer insulator 39b to 1.5. To form the upper first interlayer insulator 39b having a thickness equal to 1.9 or larger, special equipment and method are required to increase the amount of nitrogen in the upper first interlayer insulator 39b. Namely, it is difficult to form the upper first interlayer insulators 39b by general fabrication equipment. By setting the upper limit of the refractive index of the upper first interlayer insulators 39b to 1.9, manufacturability, that is, formation of the upper first interlayer insulators 39b by general fabrication equipment is ensured.

From the graph in FIG. 11, which illustrates the results of comparative experiment 1, it is observed that the amounts of desorbed hydrogen in samples 7 and 8 are larger than those of samples 1 to 6. When the refractive index of the upper first interlayer insulator 39b is larger than 1.72, the amount of nitrogen in the upper first interlayer insulator 39b is large. The upper first interlayer insulator 39b tends to contain a larger amount of hydrogen that is generated during the formation of the film. Specifically, when the upper first interlayer insulator 39b is formed by reaction of silane (SiH₄) and ammonia (NH₃), hydrogen is generated. The amount of generated hydrogen varies proportional to the amount of ammonia, that is, the amount of nitrogen in the upper first interlayer insulator 39b. It is assumed that the amount of the hydrogen increases as the amount of the nitrogen increases. In samples 1 to 6, the refractive indexes of the upper first interlayer insulators 39b are set to the range from 1.5 to 1.72 and thus the amounts of desorbed hydrogen are small. Therefore, the amounts of hydrogen taken into the second channels 29d are sufficiently small. From the results of comparative experiment 1, it is preferable to set the refractive index of each upper first interlayer insulator 39b in the range from 1.5 to 1.9 to ensure sufficient moisture resistance and manufacturability of the upper first interlayer insulators 39b using general fabrication equipment. It is more preferable to set the refractive index in a range from 1.5 to 1.72 to reduce the amount of desorbed hydrogen.

Regarding comparative experiment 2, the non-display area TFTs 29 in comparative samples 3 and 4 do not have threshold voltages and switching properties as transistors according to the graph in FIG. 12. An absolute value of the amount of hydrogen in the upper first interlayer insulator 39b becomes too large to remain when the thickness of the upper first interlayer insulator 39b is larger than 75 nm. As a result, the hydrogen desorbs from the upper first interlayer insulator 39b and the amount of hydrogen taken into the second channel 29d formed from the oxide semiconductor layer 36 increases. The electrical characteristics of the second channel 29d becomes similar to those of a conductor, that is, the second channel 29d does not function as a semiconductor. In samples 1 and 2 and comparative samples 1 and 2, the thicknesses of the upper first interlayer insulators 39b are 75 nm or smaller. Therefore, the absolute value of the amount of hydrogen in each sample does not become too large and thus the amount of hydrogen taken into the second channel 29d formed from the oxide semiconductor layer 36 is small. The second channel 29d properly functions as a semiconductor.

Regarding comparative experiment 3, the thickness T1 of the upper first interlayer insulator 39b in comparative sample 1 is equal to or smaller than 25 nm. The picture in FIG. 13 indicates that the upper first interlayer insulator 39b has cracks (gaps) 42. When the thickness of the upper first interlayer insulator 39b is equal to or smaller than 25 nm, coverage of the upper first interlayer insulator 39b to the lower first interlayer insulator 39a decreases . Moisture is more likely to enter through the cracks 42, that is, the moisture resistance decreases. The thickness T2 of the upper first interlayer insulator 39b in sample 1 is 35 nm. The picture in FIG. 14 indicates that the upper first interlayer insulator 39b does not have cracks 42. When the thickness of the upper first interlayer insulator 39b is equal to or smaller than 35 nm, proper coverage of the upper first interlayer insulator 39b to the lower first interlayer insulator 39a is achieved and thus sufficient moisture resistance is ensured. From the results of comparative samples 2 and 3, it is preferable to set the thickness of the upper first interlayer insulator 39b in a range from 35 nm to 75 nm to reduce the amount of desorbed hydrogen and to ensure sufficient moisture resistance.

As described above, the liquid crystal panel (a display device) 11 according to this embodiment includes the array board (a substrate) 11b, the display area TFTs (display area transistors) 17, the non-display area TFTs (non-display area transistors) 29, and the first interlayer insulators 39. The array board 11b includes the display area AA and the non-display area NAA. The display area AA is located inner and the non-display area NAA is located outer so as to surround the display area AA. The display area TFTs 17 are disposed in the display area AA. The non-display area TFTs 29 are disposed in the non-display area NAA. Each non-display area TFT 29 includes the second gate electrode (a gate electrode) 29a, the second channel 29d, the second source electrode (a source electrode) 29b, and the second drain electrode (a drain electrode) 29c. At least a portion of the second channel 29d overlaps the second gate electrode 29a in a plan view. The second channel 29d is formed from the oxide semiconductor film 36. At least a portion of the source electrode 29b is layered on the second channel 29d formed from the oxide semiconductor film 36 and connected to the second channel 29d formed from the oxide semiconductor film 36. At least a portion of the second drain electrode 29c is layered on the second channel 29d formed from the oxide semiconductor film 36 and connected to the second channel 29d formed from the oxide semiconductor film 36 with a gap between the second source electrode 29b and the second drain electrode 29c. The first interlayer insulator 39 is layered at least on the second source electrode 29b and the second drain electrode 29c. The first interlayer insulator 39 has the multilayer structure including the lower first interlayer insulator (a lower insulator) 39a and the upper first interlayer insulator (an upper insulator) 39b. The lower first interlayer insulator 39a is disposed in the lower layer. The lower first interlayer insulator 39a contains at least silicon and oxygen. The upper first interlayer insulator 39b is disposed in the upper layer. The upper first interlayer insulator 39b contains at least silicon and nitrogen. The thickness of the upper first interlayer insulator 39b is in the range from 35 nm to 75 nm.

According to this configuration, in each non-display area TFT 29, when a voltage is applied to the second gate electrode 29a, a current starts flowing between the second source electrode 29b and the second drain electrode 29c via the second channel 29d formed from the oxide semiconductor film 36. The second channel 29d formed from the oxide semiconductor film 36 has higher electron mobility in comparison to the amorphous silicon thin film. Therefore, this configuration is preferable for passing a larger current between the second source electrode 29b and the second drain electrode 29c.

According to the configuration of the array board 11b in which the non-display area NAA is arranged outer so as to surround the display area AA arranged inner, the non-display area TFTs 29 in the non-display area NAA are more likely to be affected by the moisture from the outside in comparison to the display area TFTs 17 in the display area AA. If the second channel 29d formed from the oxide semiconductor film 36 in each non-display area TFT 29 takes the moisture therein and the second channel 29d is deteriorated, the electrical characteristics of the second channel 29d formed from the oxide semiconductor film 36 change. As a result, a malfunction of the non-display area TFT 29 may occur.

The first interlayer insulator 39 is layered at least on the second source electrode 29b and the second drain electrode 29c. The first interlayer insulator 39 has the multilayer structure including the lower first interlayer insulator 39a and the upper first interlayer insulator 39b. The lower first interlayer insulator 39a is disposed in the lower layer. The lower first interlayer insulator 39a contains at least silicon and oxygen. The upper first interlayer insulator 39b is disposed in the upper layer. The upper first interlayer insulator 39b contains at least silicon and nitrogen. With the upper first interlayer insulator 39b, the moisture from the outside is less likely to reach the second channel 29d formed from the oxide semiconductor film 36. Furthermore, even if the upper first interlayer insulator 39b contains hydrogen during the formation of the film and the hydrogen is desorbed from the upper first interlayer insulator 39b, the hydrogen desorbed from the upper first interlayer insulator 39b is restricted by the lower first interlayer insulator 39a from reaching the second channel 29d formed from the oxide semiconductor film 36. Therefore, the deterioration of the second channel 29d formed from the oxide semiconductor film 36 due to the moisture and the hydrogen taken into the second channel 29d is less likely to occur and the electrical characteristics of the second channel 29d are less likely to change. As a result, the malfunction of the non-display area TFT 29 is less likely to occur.

If the thickness of the upper first interlayer insulator 39b is larger than 75 nm, a large amount of hydrogen is contained in the upper first interlayer insulator 39b during the formation of the upper first interlayer insulator 39b. Furthermore, the amount of hydrogen desorbed from the upper first interlayer insulator 39b tends to increase. Therefore, the second channel 29d formed from the oxide semiconductor film 36 may be deteriorated by the hydrogen desorbed from the upper first interlayer insulator 39b and the electrical characteristics thereof are more likely to change. If the thickness of the upper first interlayer insulator 39b is smaller than 35 nm, the coverage of the upper first interlayer insulator 39b to the lower first interlayer insulator 39a decreases. The cracks (gaps) are more likely to be created and thus the moisture resistance decreases. As a result, the second channel 29d formed from the oxide semiconductor film 36 is more likely to take the moisture therein. When the thickness of the upper first interlayer insulator 39b is in the range from 35 nm to 75 nm, the amount of hydrogen desorbed from the upper first interlayer insulator 39b is small. The sufficient moisture resistance of the upper first interlayer insulator 39b is provided and the electrical characteristics of the second channel 29d formed from the oxide semiconductor film 36 are less likely to change. Therefore, the malfunction of the non-display area TFT 29 is less likely to occur. Because the upper first interlayer insulator 39b has the sufficient moisture resistance, the second source electrode 29b and the second drain electrode 29c are less likely to be corroded by the moisture.

The refractive index of the upper first interlayer insulator 39b of the first interlayer insulator 39 is in the range from 1.5 to 1.9. The refractive index of the upper first interlayer insulator 39b varies according to the composition. Specifically, if the content of the nitrogen decreases, the refractive index tends to decrease. If the content of the nitrogen increases, the refractive index tends to increase. If the refractive index of the upper first interlayer insulator 39b is equal to or smaller than 1.5, the content of nitrogen is small and thus the moisture resistance is low. Namely, the moisture is more likely to enter the second channel 29d formed from the oxide semiconductor film 36, which may results in adverse effect on the electrical characteristics of the second channel 29d formed from the oxide semiconductor film 36. If the refractive index of the upper first interlayer insulator 39b is equal to or larger than 1.9, the content of nitrogen is large and thus it may be difficult to form the film by general fabrication equipment. If the refractive index of the upper first interlayer insulator 39b is in the range from 1.5 to 1.9, the sufficient moisture resistance is ensured. The electrical characteristics of the second channel 29d formed from the oxide semiconductor film 36 are less likely to change and thus the film is easily formed by general fabrication equipment.

The refractive index of the upper first interlayer insulator 39b of the first interlayer insulator 39 is in the range from 1.5 to 1.72. During the formation of the film, the content of hydrogen in the upper first interlayer insulator 39b tends to increase as the content of hydrogen in the upper first interlayer insulator 39b increases. The upper limit of the refractive index of the upper first interlayer insulator 39b is 1.72. The content of hydrogen in the upper first interlayer insulator 39b is small and thus the amount of hydrogen desorbed from the upper first interlayer insulator 39b is small. Therefore, the electrical characteristics of the second channel 29d formed from the oxide semiconductor film 36 are less likely to change due to the hydrogen desorbed from the upper first interlayer insulator 39b.

The liquid crystal panel 11 further includes the CF board (a counter substrate) 11a, the liquid crystal layer (liquid crystals) 11c, and the sealing member 11j. The CF board 11a is apposite the array board 11b. The liquid crystal layer 11c is sandwiched between the array board 11b and the CF board 11a. The sealing member 11j is between the array board 11b and the CF board 11a. The sealing member 11j is disposed so as to surround the liquid crystal layer 11c and seals the liquid crystal layer 11c. The non-display area TFTs 29 are arranged closer to the sealing member 11j with respect to the display area TFTs 17. The liquid crystal layer 11c between the array board 11b and the CF board 11a is sealed by the sealing member 11j disposed between the array board 11b and the CF board 11a so as to surround the liquid crystal layer 11c. The non-display area TFTs 29 are arranged closer to the sealing member 11j with respect to the display area TFTs 17 and thus more likely to be subject to the moisture from the outside and permeated through the seating member 11j. As described above, the first interlayer insulator 39 has the multilayer structure including the upper first interlayer insulator 39b and the lower first interlayer insulator 39a. Furthermore, the thickness of the upper first interlayer insulator 39b is in the range from 35 nm to75 nm. Therefore, the moisture permeated through the sealing member 11j is less likely to be taken into the second channel 29d formed from the oxide semiconductor film 36 in each non-display area TFT 29. According to this configuration, the malfunctions of the non-display area TFTs 29 are less likely to occur.

The second channel 29d formed from the oxide semiconductor film 36 includes the second extending portion (an extending portion) 29d1. The second extending portion 29d1 projects toward the opposite direction to the second source electrode 29b at the position at which the second drain electrode 29c is connected. At least a portion of the extending portion 29d1 does not overlap the second gate electrode 29a in a plan view. The second channel 29d formed from the oxide semiconductor film 36 has such a configuration. Namely, the second channel 29d includes the second extending portion 29d1 that projects toward the opposite direction to the second source electrode 29b at the position at which the second drain electrode 29c is connected. Because the portion of the second extending portion 29d1, which does not overlap the second gate electrode 29a in a plan view, the light from the outside toward the non-overlapping portion of the second extending portion 29d1 is less likely to be blocked by the second gate electrode 29a. Namely, the non-overlapping portion is more likely to be subject to the irradiation of the light and thus the electrical characteristics thereof may degrade. Specifically, the second channel 29d formed from the oxide semiconductor film 36 has characteristics that the charge transferability is more likely to be affected when the second channel 29d receives optical energy. During driving of the non-display area TFT 29, the non-overlapping portion of the second extending portion 29d1 may be more likely to be charged. In addition to such a problem, the electrical characteristics of the second channel 29d formed from the oxide semiconductor film 36 may change due to the moisture and the hydrogen taken into the second channel 29d. If such a problem occurs, the malfunction of the non-display area TFT 29 is more likely to occur. However, the first interlayer insulator 39 has the multilayer structure including the upper first interlayer insulator 39b and the lower first interlayer insulator 39a. Furthermore, the thickness of the upper first interlayer insulator 39b is in the range from 35nm to 75 nm. According to the configuration, the second channel 39d formed from the oxide semiconductor film 36 is less likely to take the moisture and the hydrogen therein. Therefore, the malfunction of the non-display TFT 29 is less likely to occur.

Each non-display area TFT 29 further includes the second protection portion 29e formed from the protection film 37 for protecting the second channel 29d formed the oxide semiconductor film 36. The second protection portion 29e includes a pair of the second holes (holes) 29e1, 29e2. The second holes 29e1, 29e2 are located between the second source electrode 29b and the second channel 29d and between the second drain electrode 29c and the second channel 29d, respectively. The second holes 29e1, 29e2 are formed at the positions overlapping the second source electrode 29b and the second drain electrode 29c, respectively. The second source electrode 29b and the second drain electrode 29c are connected to the second channel 29d via the second holes 29e1, 29e2, respectively. With this configuration, when etching is performed during the formation of the second source electrode 29b and the second drain electrode 29c in the fabrication process, the second channel 29d is protected from being etched by the second protection portion 29e formed from the protection film 37 in the upper layer. In the fabrication process, the second channel 29d formed from the oxide semiconductor film 36 is protected by the second protection portion 29e formed from the protection film 37. The hydrogen is further less likely to enter the second channel 29d formed from the oxide semiconductor film 36 and thus the malfunction of the non-display area TFT 29 is less likely to occur. The second protection portion 29e formed from the protection film 37 includes a pair of the second holes 29el, 29e2 formed at the positions overlapping the second source electrode 29b and the second drain electrode 29c in a plan view. The second source electrode 29b and the second drain electrode 29c are connected to the second channel 29d formed from the oxide semiconductor film 36 via the holes.

Each second protection portion 29e formed from the protection film 37 contains at least silicon and oxygen. The second protection portion 29e formed from the protection film 37 has such a configuration, that is, contains at least silicon and oxygen. According to the configuration, the amount of the hydrogen desorbed from the protection film 37 is small. Therefore, the second channel 28d formed from the oxide semiconductor film 36 is less likely to take the hydrogen therein and thus the malfunction of the non-display area TFT 29 is further less likely to occur.

Each second channel 29d formed from the oxide semiconductor film 36 contains at least indium, gallium, and zinc. Such a second channel 29d formed from the oxide semiconductor film 36 and containing at least indium, gallium, and zinc tends to deteriorate due to the moisture and the hydrogen. As described above, the first interlayer insulator 39 has the multilayer structure including the upper first interlayer insulator 39b and the lower first interlayer insulator 39a. Furthermore, the thickness of the upper first interlayer insulator 39b is in the range from 35 nm to 75 nm. According to the configuration, the second channel 29d formed from the oxide semiconductor film 36 is less likely to take the moisture and the hydrogen therein. Therefore, the malfunction of the non-display area TFT 29 is less likely to occur.

The liquid crystal panel 11 includes the gate lines (scan signal lines) 19 and the buffer circuit 26. The gate lines 29 are disposed in the display area AA and connected to the display area TFTs 17 to transmit the scan signals to the display area TFTs 17. The buffer circuit 26 is disposed in the non-display area NAA and connected to the gate lines 19. The buffer circuit 26 supplies the scan signals. The non-display area TFTs 29 are included in the buffer circuit 26. According to the configuration, the current that flows between the second source electrode 29b and the second drain electrode 29c in each non-display TFT 29 in the buffer circuit 26 is larger in comparison to the display area TFT 17. Therefore, if the second channel 29d deteriorates due to the moisture or the hydrogen taken therein and the electrical characteristics of the second channel 29d formed from the oxide semiconductor film 36 in the non-display area TFT 29 change, the malfunction of the second channel 29d is more likely to occur. As described above, the first interlayer insulator 39 has the multilayer structure including the upper first interlayer insulator 39b and the lower first interlayer insulator 39a. Furthermore, the thickness of the upper first interlayer insulator 39b is in the range from 35 nm to 75 nm. According to the configuration, the second channel 29d formed from the oxide semiconductor film 36 is less likely to take the moisture and the hydrogen therein. Therefore, the malfunctions of the non-display TFTs 29 in the buffer circuit 26 are less likely to occur.

Each of the second source electrodes 29b and the second drain electrodes 29c contains at least copper. In comparison to a configuration in which each of those containing aluminum, each of the second source electrodes 29b and the second drain electrodes 29c containing copper has higher electrical conductivity but tends to be corroded by the moisture. As described above, the first interlayer insulator 39 has the multilayer structure including the upper first interlayer insulator 39b and the lower first interlayer insulator 39a. Furthermore, the thickness of the upper first interlayer insulator 39b is in the range from 35 nm to 75 nm. According to the configuration, the moisture from the outside is less likely to permeate through the first interlayer insulator 39 and to reach the second source electrode 29b and the second drain electrode 29c. Therefore, the second source electrode 29b and the second drain electrode 29c are less likely to be corroded by the moisture.

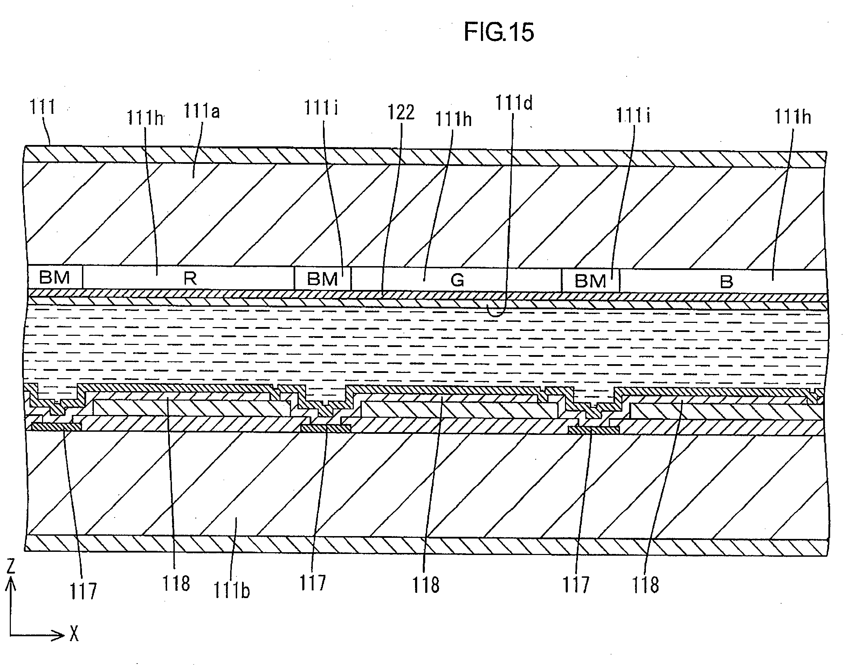

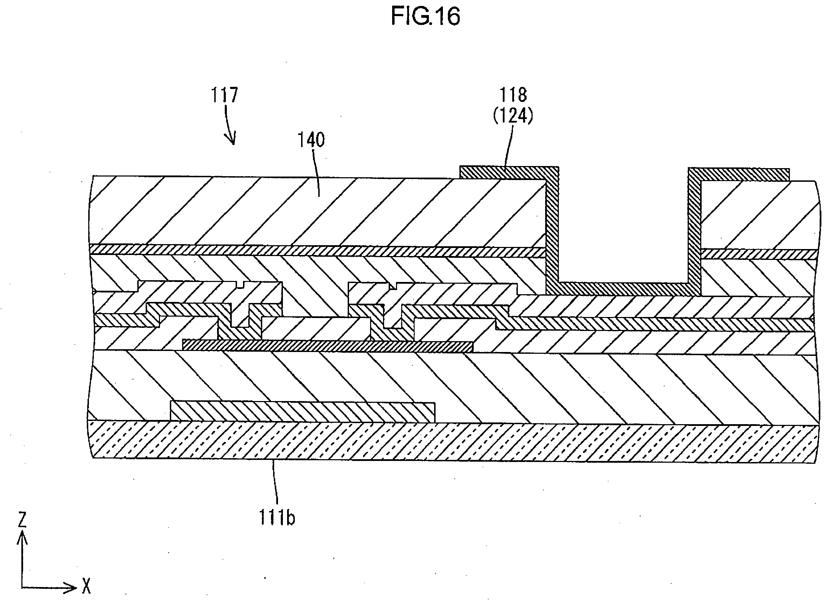

With regard to FIGS. 15 and 16 a common electrode 122 is disposed on a CF board 111a. Similar configurations, operations, and effects above will not be described.

As illustrated in FIG. 15, a liquid crystal panel 111 includes the common electrode 122 disposed on the CF board 111a but not on an array board 111b including display area TFTs 117. The operation mode of the liquid crystal panel 111 is vertical alignment (VA) mode. The common electrode 122 is disposed between an alignment film 111d and a layer including a color filter 111h and a light blocking layer 111i. The common electrode 122 is a solid pattern disposed in about a whole area of a surface of a CF board 111a. As illustrated in FIG. 16, the common electrode 122 is not on the array board 111b and thus the second interlayer film is not included. A second transparent electrode film 124 (a pixel electrode 118) is directly layered on an organic insulator 140 in the upper layer. According to such a configuration, functions and effects similar to those of the first embodiment can be achieved.

### <Third Embodiment>

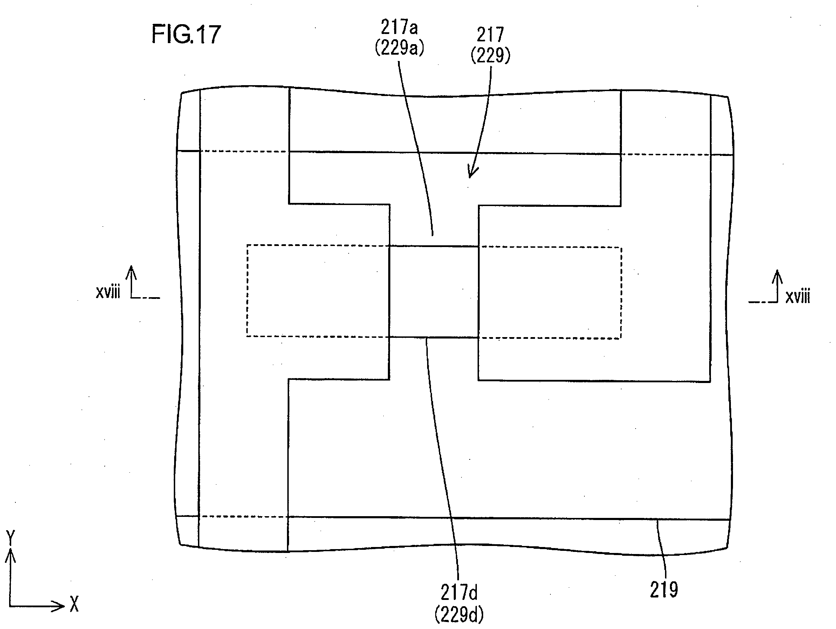

A third embodiment according to the present invention will be described with reference to FIGS. 17 to 19. The third embodiment includes gate electrodes 217a, 229a of TFTs 217, 229, arrangements of which in a plan view are different from those in the first embodiment. Similar configurations, operations, and effects to the first embodiment will not be described.

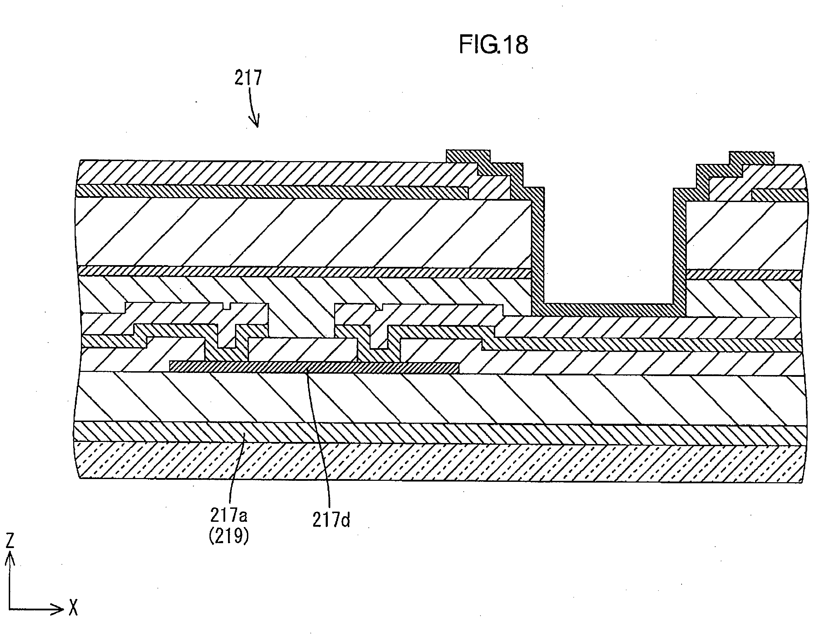

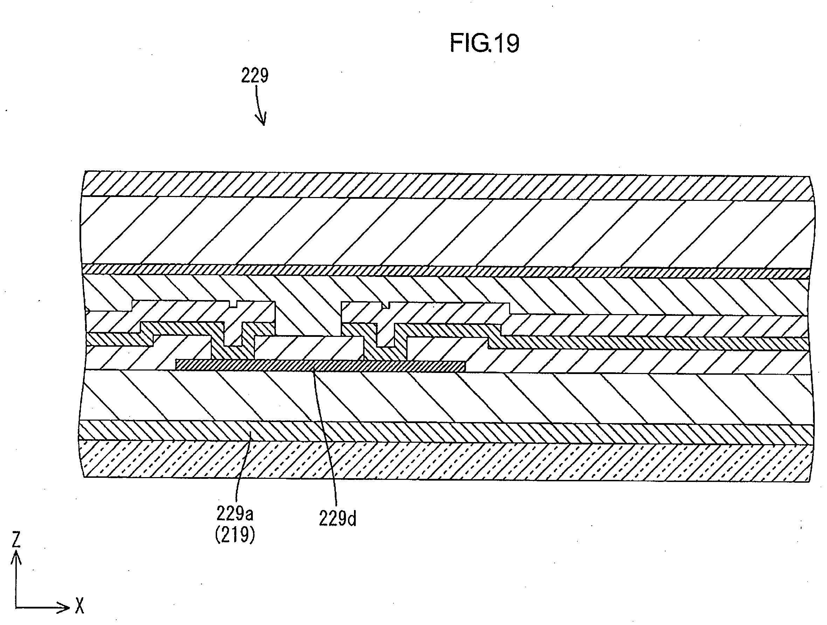

As illustrated in FIGS. 17 and 18, a first gate electrode 217a in each display area TFT 217 is integrally formed a corresponding gate line 219 without branching from the gate line 219. Namely, the display area TFT 217 is arranged entirely on the gate line 219. An entire area of a first channel 217d in the display area TFT 217 is on the first gate electrode 217a (a gate line 219) in a plan view. Similarly, a second gate electrode 229a in each non-display area TFT 229 is integrally formed a corresponding gate line 219 without branching off the gate line 219 as illustrated in FIGS. 17 and 19. Namely, the non-display area TFT 229 is arranged entirely on the gate line 219. An entire area of a second channel 229d in the non-display area TFT 229 is on the second gate electrode 229a (a gate line 219) in a plan view. According to the configuration, the electrical characteristics of each of the channels 217d, 229d are less likely to change and thus a malfunction of each of the TFTs 217, 229 are less likely to occur. According to such a configuration, functions and effects similar to those of the first embodiment can be achieved.

### <Other Embodiments>

The present invention is not limited to the embodiments described above and illustrated by the drawings. For examples, the following embodiments will be included in the technical scope of the present invention.
(1) In each of the above embodiments, the refractive index of the upper first interlayer insulator is in the range from 1.5 to 1.9. If production technologies improve and the upper first interlayer insulator having the refractive index equal to or higher than 1.9 is formable by general fabrication equipment, the refractive index of the upper first interlayer insulator may be set to 1.9 or higher.
(2) In each of the above embodiments, mixed gas of silane (SiH₄) and ammonia (NH₃) is used as an example in the formation of the upper first interlayer insulator. However, other mixed gas may be used. For example, mixed gas of silane (SiH₄) and nitrogen (N₂) may be used, or dichlorosilane (SiH₂Cl₂) may be used instead of silane (SiH₄). Furthermore, mixed gas of silane, ammonia, and nitrogen may be used to form the upper first interlayer insulator.
(3) In each of the above embodiment, the non-display area TFTs disposed in the non-display area are configured to output scan signals at the final stage of the signal processing in the scanning circuits. However, the scope of the present invention is applicable to non-display area TFTs having other functions.
(4) Non-display area TFTs having different functions are disposed in the non-display area other than the non-display area TFTs in the buffer circuit.
(5) In each of the above embodiments, the thickness and the refractive index of the upper first interlayer insulator in each of the display area TFTs and the non-display area TFTs are within the ranges.
(6) Each of the above embodiments includes the non-display area TFTs in the row control circuit disposed in the non-display area. The scope of the present invention is applicable to the non-display area TFTs in the column control circuit disposed in the non-display area.
(7) The arrangement and the number of the row control circuit on the array board may be altered from those of the above embodiments . For example, the row control circuit may be disposed adjacent to the display area on the right in FIG. 5. Furthermore, a pair of row control circuits may be disposed on either side of the display area sandwiching the display area from right and left.
(8) The materials of the gate insulators, the organic insulators, and the second interlayer insulators may be altered from those of the above embodiments as appropriate.
(9) The gate insulator in each of the above embodiments is the single layered film. However, the gate insulator may include multi layers made of different materials. For example, the gate insulator may have a multilayer structure including a lower gate insulator made of silicon nitride (SiNx) and an upper gate insulator made of silicon oxide (SiO₂), which are layered in sequence opposite from the first interlayer insulator.
(10) In each of the above embodiments, the oxide semiconductor film is the oxide thin film that contains indium (In), gallium (Ga), and zinc (Zn). However, other types of oxide semiconductors may be used. Examples of oxides include an oxide that contains indium (In), silicon (Si), and zinc (Zn), an oxide that contains indium (In), aluminum (Al), and zinc (Zn), an oxide that contains tin (Sn), silicon (Si), and zinc (Zn), an oxide that contains tin (Sn), aluminum (Al), and zinc (Zn), an oxide that contains tin (Sn), gallium (Ga), and zinc (Zn), an oxide that contains gallium (Ga), silicon (Si), and zinc (Zn), an oxide that contains gallium (Ga), aluminum (Al), and zinc (Zn), an oxide that contains indium (In), copper (Cu), and zinc (Zn), and an oxide that contains tin (Sn), copper (Cu), and zinc (Zn).
(11) During formation of contact holes in the display transistor in each of the above embodiments, the first interlayer insulator and the organic insulator are etched using the second interlayer insulator having the hole as a resist. However, the holes of the first interlayer insulator, the organic insulator, and the second interlayer insulator may be formed, respectively, by patterning during formation thereof. The arrangement of the contact holes in a plan view may be altered as appropriate.
(12) Each of the above embodiments includes the liquid crystal panel that includes the FFS mode or the VA mode as an operation mode. However, the scope of the present invention is applicable to other liquid crystal panels that include an in-plane switching (IPS) mode as an operation mode.
(13) In the liquid crystal panel in each of the above embodiments, the display area is arranged medially with respect to the short-side direction but closer to one of the ends with respect to the long-side direction. However, the display area of the liquid crystal panel may be arranged medially with respect to the long-side direction but closer to one of the ends with respect to the short-side direction. The display area of the liquid crystal panel may be arranged closes to one of the ends with respect to the long-side direction and to one of the ends with respect to the short-side direction. The display area of the liquid crystal panel may be arranged medially with respect to the long-side direction and at the middle with respect to the short-side direction.
(14) Each of the above embodiments includes the second metal film that is formed from a multilayer film of titanium (Ti) and copper (Cu). However, the following materials may be used instead of titanium: molybdenum (Mo), molybdenum nitride (MoN), titanium nitride (TiN), tungsten (W), niobium (Nb), molybdenum-titanium alloy (MoTi), and molybdenum-tungsten (MoW) alloy. Furthermore, aluminum (A1) may be used instead of copper. Still furthermore, a single-layered metal film such as a titanium film, a cupper film, or an aluminum film may be used.
(15) Each of the above embodiments includes the driver that is directly mounted on the array board through the COG method. A driver that is mounted on a flexible printed circuit board that is connected to the array board via an ACF is also included in the scope of the present invention.
(16) Each of the above embodiments includes the column control circuit and the row control circuit dispose in the non-display area of the array board. However, any one of the column control circuit and the row control circuit may be omitted, and the driver may be configured to perform the functions of the omitted circuit.
(17) Each of the above embodiments includes the liquid crystal panel having a vertically-long rectangular shape. However, liquid crystal panels having a horizontally-long rectangular shape of a square shape are also included in the scope of the present invention.
(18) Each of the above embodiments may further include a functional panel that are layered on and attached to the liquid crystal panel, such as a touch panel and a parallax barrier panel (a switching liquid crystal panel) . Furthermore, a liquid crystal panel including touch panel patterns directly formed thereon is also included in the scope of the present invention.
(19) The liquid crystal display device according to the above embodiments includes the edge-light type backlight unit. However, the liquid crystal display device may include a direct backlight unit.
(20) The transmission type liquid crystal display devices each including the backlight unit, which is an external light source, are described as the embodiments. However, reflection type liquid crystal display devices that use outside light to display images are also included in the scope of the present invention. The reflection type liquid crystal display devices do not require backlight units.
(21) Each of the above embodiments includes the TFTs as switching components of the liquid crystal display device. However, liquid crystal display devices that include switching components other than TFTs (e.g., thin film diodes (TFDs)) may be included in the scope of the present invention. Furthermore, black-and-white liquid crystal display devices, other than color liquid crystal display device, are also included in the scope of the present invention.
(22) The liquid crystal display devices including the liquid crystal panels as the display panels are described as the embodiments. However, display devices that include other types of display panels (e.g., plasma display panels (PDPs) and organic EL panels) are also included in the scope of the present invention. Such display devices do not require backlight units.
(23) The above embodiments include the liquid crystal panels that are classified as small sized or small to middle sized panels. Such liquid crystal panels are used in electronic devices including PDAs, mobile phones, notebook computers, digital photo frames, portable video games, and electronic ink papers. However, liquid crystal panels that are classified as middle sized or large sized (or supersized) panels having screen sizes from 20 inches to 90 inches are also included in the scope of the present invention. Such display panels may be used in electronic devices including television devices, digital signage, and electronic blackboard.
(24) In the first and the second embodiments, the first channel of each display area TFT includes the first extending portion that does not overlap the first gate electrode in a plan view. The second channel of each non-display area TFT includes the second extending portion that does not overlap the second gate electrode in a plan view. While the first channel of each display area TFT may have the same arrangement as the first and the second embodiment, each non-display area TFT may include the second channel, an entire area of which is over the second gate electrode in a plan view (i.e., the same arrangement as the third embodiment) . While the second channel of each non-display area TFT may have the same arrangement as the first and the second embodiment, each display area TFT may include the first channel, an entire area of which is over the first gate electrode (i.e., the same arrangement as the third embodiment).
(25) The gate electrode of each TFT in the first and the second embodiments includes the gate electrode that is branched off the gate line and the channel that includes the extending portion overlapping the gate electrode in a plan view. The channel may be configured such that an entire area thereof overlaps the gate electrode that is branched off the gate line. This configuration is applicable to one of the display area TFT and the non-display area TFT or to both of them. If the configuration is applied to one of the display area TFT and the non-display area TFT, the TFTs to which the configuration may have not applied may be disposed similar to the first and the second embodiment.
(26) The first metal film in each of the above embodiment is the single layer film of copper (Cu) . Titanium (Ti) or aluminum (Al) may be used instead of copper. The first metal film may be a multilayer film of titanium (Ti) and copper (Cu), similar to the second metal film. If the first metal film is the multilayer film, molybdenum (Mo), molybdenum nitride (MoN), titanium nitride (TiN), tungsten (W), niobium (Nb), molybdenum-titanium alloy (MoTi), and molybdenum-tungsten (MoW) alloy may be used instead of titanium in the lower layer.

### Explanation of Symbols

11, 111: liquid crystal panel (display panel), 11a, 111a: CF board (counter substrate), 11b, 11b: array board (substrate), 11c: liquid crystal layer (liquid crystals), 11j: sealing member, 17, 117, 217: display area TFT (display area transistor), 19, 219: gate line (scan signal line), 26: buffer circuit, 29, 229: non-display area TFT (non-display area transistor), 29a, 229a: second gate electrode (gate electrode), 29b: second source electrode (source electrode), 29c: second drain electrode (drain electrode), 29d, 229d: second channel (oxide semiconductor layer), 29d1: second extending portion (extending portion), 29e: second protection portion (protection film), 29e1, 29e2: second hole (hole), 34: first metal film (gate electrode), 36: oxide semiconductor layer, 37: protection film, 38: second metal film (source electrode, drain electrode), 39: first interlayer insulator (insulator), 39a: lower first interlayer insulator (lower insulator), 39b: upper first interlayer insulator(upper insulator), AA: display area, NAA: non-display area

## Claims

1. A display device (11) comprising:
a substrate (11b) including a display area (AA) and a non-display area (NAA), the display area (AA) being configured to display images and located medially, the non-display area (NAA) being located closer to peripheral edges of the substrate (11b) so as to surround the display area (AA);
a display area transistor (17) disposed in the display area (AA);
a non-display area transistor (29) disposed in the non-display area (NAA);
a gate electrode (29a) included in the non-display area transistor (29);
an oxide semiconductor film (36) included in the non-display area transistor (29), at least a portion of the oxide semiconductor film (36) overlapping the gate electrode (29a) in a plan view;
a source electrode (29b) included in the non-display area transistor (29), at least a portion of the source electrode (29b) being layered on the oxide semiconductor film (36) in a plan view and connected to the oxide semiconductor film (36);
a drain electrode (29c) included in the non-display area transistor (29), at least a portion of the drain electrode (29c) being layered on the oxide semiconductor film (36) and connected to the oxide semiconductor film (36) with a gap between the source electrode (29b) and the drain electrode (29c);
a protection film (37) made of silicon oxide for protecting the oxide semiconductor film (36), the protection film (37) being disposed between the source electrode (29b) and the oxide semiconductor film (36) and between the drain electrode (29c) and the oxide semiconductor film (36), the protection film (37) including a pair of holes (29e1, 29e2) formed at positions overlapping the source electrode (29b) and the drain electrode (29c), respectively, in a plan view and through which the source electrode (29b) and the drain electrode (29c) are connected to the oxide semiconductor film (36); and
an insulator (39) covering the source electrode (29b), the drain electrode (29c), and the oxide semiconductor film (36) from above, the insulator (39) having a multilayer structure including a lower insulator (39a) and an upper insulator (39b), **characterized in that**
the lower insulator (39a), which is made of silicon oxide, is disposed in a lower layer so that hydrogen desorbed from the upper insulator (39b) is less likely to permeate through the lower insulator (39a),
the upper insulator (39b), which is made of silicon nitride, is disposed in an upper layer so that moisture is less likely to permeate through the upper insulator (39b) and less likely to reach the oxide semiconductor film (36), and
the upper insulator (39b) has a thickness in a range from 35 nm to 75 nm.

2. The display device (11) according to claim 1, wherein the upper insulator (39b) of the insulator (39) has a refractive index in a range from 1.5 to 1.9.

3. The display device (11) according to claim 2, wherein the refractive index of the upper insulator (39b) of the insulator (39) is in a range from 1.5 to 1.72.

4. The display device (11) according to any one of claims 1 to 3, further comprising:
a counter substrate (11a) disposed opposite the substrate (11b);
liquid crystals (11c) sandwiched between the substrate (11b) and the counter substrate (11a); and
a sealing member (11j) disposed between the substrate (11b) and the counter substrate (11a) so as to surround the liquid crystals (11c) and sealing the liquid crystals (11c),
wherein the non-display area transistor (29) is disposed closer to the sealing member (11j) than the display area transistor (17).

5. The display device (11) according to anyone of claims 1 to 4, wherein the oxide semiconductor film (36) includes an extending portion (29d1) that projects toward an opposite direction to the source electrode (29b) at a position at which the drain electrode (29c) is connected, at least a portion of the extending portion (29d1) does not overlap the gate electrode (29a) in a plan view.

6. The display device (11) according to any one of the preceding claims, wherein the protection film (37) contains at least silicon and oxygen.

7. The display device (11) according to any one of the preceding claims, wherein the oxide semiconductor film (36) contains at least indium, gallium, and zinc.

8. The display device (11) according to any one of the preceding claims, further comprising:
a scan signal line (19) disposed in the display area (AA) and connected to the display area transistor (17) to transmit scan signals to the display area transistor (17); and
a buffer circuit (26) disposed in the non-display area (NAA) and connected to the scan signal line (19),
wherein the non-display area transistor (29) is included in the buffer circuit (26).

9. The display device (11) according to any one of the preceding claims, wherein the source electrode (29b) and the drain electrode (29c) contain at least copper.

10. The display device (11) according to claim 7, wherein the oxide semiconductor film is crystalline.

## Patentansprüche

1. Anzeigevorrichtung (11), umfassend:
ein Substrat (11b), das einen Anzeigebereich (AA) und einen Nicht-Anzeigebereich (NAA) umfasst, wobei der Anzeigebereich (AA) ausgestaltet ist, Bilder anzuzeigen und mittig angeordnet ist, wobei der Nicht-Anzeigebereich näher an Umfangskanten des Substrats (11b) angeordnet ist, sodass er den Anzeigebereich (AA) umgibt;
einen Anzeigebereichstransistor (17), der in dem Anzeigebereich (AA) angeordnet ist;
einen Nicht-Anzeigebereichstransistor (29), der in dem Nicht-Anzeigebereich (NAA) angeordnet ist;
eine Gate-Elektrode (29a), die in dem Nicht-Anzeigebereichstransistor (29) umfasst ist;
einen Oxidhalbleiterfilm (36), die in dem Nicht-Anzeigebereichstransistor (29) umfasst ist, wobei mindestens ein Abschnitt des Oxidhalbleiterfilms (36) die Gate-Elektrode (29a) in einer Draufsicht überlappt;
eine Source-Elektrode (29b), die in dem Nicht-Anzeigebereichstransistor (29) umfasst ist, wobei mindestens ein Abschnitt der Source-Elektrode (29b) in einer Draufsicht auf den Oxidhalbleiterfilm (36) geschichtet ist und mit dem Oxidhalbleiterfilm (36) verbunden ist;
eine Drain-Elektrode (29c), die in dem Nicht-Anzeigebereichstransistor (29) umfasst ist, wobei mindestens ein Abschnitt der Drain-Elektrode (29c) auf den Oxidhalbleiterfilm (36) geschichtet ist und mit einem Spalt zwischen der Source-Elektrode (29b) und der Drain-Elektrode (29c) mit dem Oxidhalbleiterfilm (36) verbunden ist;
ein Schutzfilm (37), der aus Siliziumoxid gefertigt ist, zum Schützen des Oxidhalbleiterfilms (36), wobei der Schutzfilm (37) zwischen der Source-Elektrode (29b) und dem Oxidhalbleiterfilm (36) und zwischen der Drain-Elektrode (29c) und dem Oxidhalbleiterfilm (36) angeordnet ist, wobei der Schutzfilm (37) ein Paar von Löchern (29e1, 29e2) umfasst, die an Positionen ausgebildet sind, die die Source-Elektrode (29b) und die Drain-Elektrode (29c) jeweils in einer Draufsicht überlappen und durch die die Source-Elektrode (29b) und die Drain-Elektrode (29c) mit dem Oxidhalbleiterfilm (36) verbunden sind; und
einen Isolator (39), der die Source-Elektrode (29b), die Drain-Elektrode (29c) und der Oxidhalbleiterfilm (36) von oben abdeckt, wobei der Isolator (39) eine Mehrschichtstruktur aufweist, umfassend einen unteren Isolator (39a) und einen oberen Isolator (39b), **dadurch gekennzeichnet, dass**
der untere Isolator (39a), der aus Siliziumoxid gefertigt ist, in einer unteren Schicht angeordnet ist, sodass Wasserstoff, der von dem oberen Isolator (39b) desorbiert wird, weniger wahrscheinlich durch den unteren Isolator (39a) hindurchtritt,
der obere Isolator (39a), der aus Siliziumnitrid gefertigt ist, in einer oberen Schicht angeordnet ist, sodass Feuchte weniger wahrscheinlich durch den oberen Isolator (39b) hindurchtritt und weniger wahrscheinlich den Oxidhalbleiterfilm (36) erreicht, und
der obere Isolator (39b) eine Dicke in einem Bereich von 35 nm bis 75 nm aufweist.

2. Anzeigevorrichtung (11) nach Anspruch 1, wobei der obere Isolator (39b) des Isolators (39) einen Brechungsindex in einem Bereich von 1,5 bis 1,9 aufweist.

3. Anzeigevorrichtung (11) nach Anspruch 2, wobei der Brechungsindex des oberen Isolators (39b) des Isolators (39) in einem Bereich von 1,5 bis 1,72 liegt.

4. Anzeigevorrichtung (11) nach einem der Ansprüche 1 bis 3, überdies umfassend:
ein Gegensubstrat (11a), das gegenüber von dem Substrat (11b) angeordnet ist;
Flüssigkristalle (11c), die zwischen dem Substrat (11b) und dem Gegensubstrat (11a) eingeschichtet sind; und
ein Dichtelement (11j), das zwischen dem Substrat (11b) und dem Gegensubstrat (11a) angeordnet ist, sodass es die Flüssigkristalle (11c) umgibt und die Flüssigkristalle (11c) abdichtet,
wobei der Nicht-Anzeigebereichstransistor (29) näher an dem Dichtelement (11j) angeordnet ist als der Anzeigebereichstransistor (17).

5. Anzeigevorrichtung (11) nach einem der Ansprüche 1 bis 4, wobei der Oxidhalbleiterfilm (36) einen Erstreckungsabschnitt (29dl) umfasst, der an einer Position, an der die Drain-Elektrode (29c) verbunden ist, hin zu einer der Source-Elektrode (29b) entgegengesetzten Richtung hervorsteht, wobei mindestens ein Abschnitt des Erstreckungsabschnitts (29d1) in einer Draufsicht nicht die Gate-Elektrode (29a) überlappt.

6. Anzeigevorrichtung (11) nach einem der vorhergehenden Ansprüche, wobei der Schutzfilm (37) mindestens Silizium und Sauerstoff enthält.

7. Anzeigevorrichtung (11) nach einem der vorhergehenden Ansprüche, wobei der Oxidhalbleiterfilm (36) mindestens Indium, Gallium und Zink enthält.

8. Anzeigevorrichtung (11) nach einem der vorhergehenden Ansprüche, überdies umfassend:
eine Scansignalleitung (19), die in dem Anzeigebereich (AA) angeordnet ist und mit dem Anzeigebereichstransistor (17) verbunden ist, um Scansignale dem Anzeigebereichstransistor (17) zu übermitteln; und
eine Pufferschaltung (26), die in dem Nicht-Anzeigebereich (NAA) angeordnet ist und mit der Scansignalleitung (19) verbunden ist,
wobei der Nicht-Anzeigebereichstransistor (29) in der Pufferschaltung (26) umfasst ist.

9. Anzeigevorrichtung (11) nach einem der vorhergehenden Ansprüche, wobei die Source-Elektrode (29b) und die Drain-Elektrode (29c) mindestens Kupfer enthalten.

10. Anzeigevorrichtung (11) nach Anspruch 7, wobei der Oxidhalbleiterfilm kristallin ist.

## Revendications

1. Dispositif d'affichage (11) comportant :
un substrat (11b) comprenant une zone d'affichage (AA) et une zone de non-affichage (NAA), la zone d'affichage (AA) étant configurée pour afficher des images et située au plan médian, la zone de non-affichage (NAA) étant située plus près des bords périphériques du substrat (11b) de manière à entourer la zone d'affichage (AA) ;
un transistor (17) de zone d'affichage disposé dans la zone d'affichage (AA) ;
un transistor (29) de zone de non-affichage disposé dans la zone de non-affichage (NAA) ;
une électrode de grille (29a) comprise dans le transistor (29) de zone de non-affichage ;
un film à semi-conducteurs d'oxyde (36) compris dans le transistor (29) de zone de non-affichage, au moins une portion du film à semi-conducteurs d'oxyde (36) chevauchant l'électrode de grille (29a) dans une vue en plan ;
une électrode source (29b) comprise dans le transistor (29) de zone de non-affichage, au moins une portion de l'électrode source (29b) étant superposée sur le film à semi-conducteurs d'oxyde (36) dans une vue en plan et connectée au film à semi-conducteurs d'oxyde (36) ;
une électrode de drain (29c) comprise dans le transistor (29) de zone de non-affichage, au moins une portion de l'électrode de drain (29c) étant superposée sur le film à semi-conducteurs d'oxyde (36) et connectée au film à semi-conducteurs d'oxyde (36) avec un espace entre l'électrode source (29b) et l'électrode de drain (29c) ;
un film de protection (37) constitué d'oxyde de silicium afin de protéger le film à semi-conducteurs d'oxyde (36), le film de protection (37) étant disposé entre l'électrode source (29b) et le film à semi-conducteurs d'oxyde (36) et entre l'électrode de drain (29c) et le film à semi-conducteurs d'oxyde (36), le film de protection (37) comprenant une paire de trous (29e1, 29e2) formés respectivement au niveau de positions chevauchant l'électrode source (29b) et l'électrode de drain (29c) dans une vue en plan et à travers lesquels l'électrode source (29b) et l'électrode de drain (29c) sont connectées au film à semi-conducteurs d'oxyde (36) ; et
un isolateur (39) recouvrant l'électrode source (29b), l'électrode de drain (29c) et le film à semi-conducteurs d'oxyde (36) depuis le dessus, l'isolateur (39) ayant une structure multicouche comprenant un isolateur inférieur (39a) et un isolateur supérieur (39b), **caractérisé en ce que**
l'isolateur inférieur (39a), qui est constitué d'oxyde de silicium, est disposé dans une couche inférieure de sorte que l'hydrogène désorbé de l'isolateur supérieur (39b) soit moins susceptible de se répandre à travers l'isolateur inférieur (39a),
l'isolateur supérieur (39b), qui est constitué de nitrure de silicium, est disposé dans une couche supérieure, de sorte que l'humidité soit moins susceptible de se répandre à travers l'isolateur supérieur (39b) et moins susceptible d'atteindre le film à semi-conducteurs d'oxyde (36) et
l'isolateur supérieur (39b) a une épaisseur dans une plage allant de 35 nm à 75 nm.

2. Dispositif d'affichage (11) selon la revendication 1, dans lequel l'isolateur supérieur (39b) de l'isolateur (39) a un indice de réfraction dans une plage allant de 1,5 à 1,9.

3. Dispositif d'affichage (11) selon la revendication 2, dans lequel l'indice de réfraction de l'isolateur supérieur (39b) de l'isolateur (39) se trouve dans une plage allant de 1,5 à 1,72.

4. Dispositif d'affichage (11) selon l'une quelconque des revendications 1 à 3, comportant en outre :
un contre-substrat (11a) disposé à l'opposé du substrat (11b) ;
des cristaux liquides (11c) intercalés entre le substrat (11b) et le contre-substrat (11a) ; et
un élément d'étanchéité (11j) disposé entre le substrat (11b) et le contre-substrat (11a) de manière à entourer les cristaux liquides (11c) et à étanchéifier les cristaux liquides (11c),
dans lequel le transistor (29) de zone de non-affichage est disposé plus près de l'élément d'étanchéité (11j) que le transistor (17) de zone d'affichage.

5. Dispositif d'affichage (11) selon l'une quelconque des revendications 1 à 4, dans lequel le film à semi-conducteurs d'oxyde (36) comprend une portion d'extension (29d1) qui fait saillie vers une direction opposée à l'électrode source (29b) au niveau d'une position à laquelle l'électrode de drain (29c) est connectée, au moins une portion de la portion d'extension (29d1) ne chevauche pas l'électrode de grille (29a) dans une vue en plan.

6. Dispositif d'affichage (11) selon l'une quelconque des revendications qui précèdent, dans lequel le film de protection (37) contient au moins du silicium et de l'oxygène.

7. Dispositif d'affichage (11) selon l'une quelconque des revendications qui précèdent, dans lequel le film à semi-conducteurs d'oxyde (36) contient au moins de l'indium, du gallium et du zinc.

8. Dispositif d'affichage (11) selon l'une quelconque des revendications qui précèdent, comportant en outre :
une ligne de signal de balayage (19) disposée dans la zone d'affichage (AA) et connectée au transistor (17) de zone d'affichage pour transmettre des signaux de balayage au transistor (17) de zone d'affichage ; et
un circuit tampon (26) disposé dans la zone de non-affichage (NAA) et connecté à la ligne de signal de balayage (19),
dans lequel le transistor (29) de zone de non-affichage est compris dans le circuit tampon (26).

9. Dispositif d'affichage (11) selon l'une quelconque des revendications qui précèdent, dans lequel l'électrode source (29b) et l'électrode de drain (29c) contiennent au moins du cuivre.

10. Dispositif d'affichage (11) selon la revendication 7, dans lequel le film à semi-conducteurs d'oxyde est cristallin.
